(19) Europäisches Patentamt / European Patent Office / Office européen des brevets

(11) **EP 4 672 519 A1**

(12) **EUROPEAN PATENT APPLICATION**
published in accordance with Art. 153(4) EPC

(43) Date of publication:
**31.12.2025 Bulletin 2026/01**

(21) Application number: 23927252.9

(22) Date of filing: 27.12.2023

(51) International Patent Classification (IPC):
**H01S 5/14** (2006.01)      **H01S 5/10** (2021.01)

(52) Cooperative Patent Classification (CPC):
**G01D 5/353; G01H 9/00; G01S 7/481;
G01S 7/4911; G01S 7/4912; G01S 17/02;
H01S 5/00; H01S 5/02255; H01S 5/026; H01S 5/10;
H01S 5/14; H01S 5/40**

(86) International application number:
**PCT/CN2023/142472**

(87) International publication number:
**WO 2024/187912 (19.09.2024 Gazette 2024/38)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: 14.03.2023  CN 202310311255

(71) Applicant: **Huawei Technologies Co., Ltd.
Shenzhen, Guangdong 518129 (CN)**

(72) Inventors:
• **LI, Rui
  Shenzhen, Guangdong 518129 (CN)**
• **ZHOU, Lei
  Shenzhen, Guangdong 518129 (CN)**
• **SONG, Xiaolu
  Shenzhen, Guangdong 518129 (CN)**

(74) Representative: **Goddar, Heinz J.
Boehmert & Boehmert
Anwaltspartnerschaft mbB
Pettenkoferstrasse 22
80336 München (DE)**

(54) **OPTICAL CHIP, EXTERNAL CAVITY LASER, LASER MODULE, AND LASER SENSING SYSTEM**

(57)     An optical chip (2a), an external cavity laser (101), a laser module (100), and a laser sensing system (1000) are disclosed, and belong to the laser field, to resolve a problem of low self-injection locking optical power reflected back to a gain chip (11) from a micro-ring external cavity in a narrow-linewidth integrated micro-ring external cavity laser. The optical chip (2a) includes a substrate (201) and a waveguide layer (202) disposed on the substrate (201). A first optical waveguide (21a), a bidirectional power splitting element (22) having a first port (221), a second port (222), and a third port (223), a second optical waveguide (23a), a reflection element (24), and a micro-ring optical waveguide (25a) are formed on the waveguide layer (202). A first end of the first optical waveguide (21a) is coupled to or connected to an end face of the gain chip (11) in the laser (10), and a second end of the first optical waveguide (21a) is connected to the first port (221) of the bidirectional power splitting element (22). The micro-ring optical waveguide (25a) is located on a side of the first optical waveguide (21a). One end of the second optical waveguide (23a) is connected to the second port (222) of the bidirectional power splitting element (22), and the other end of the second optical waveguide (23a) extends to another side that is of the micro-ring optical waveguide (25a) and that is away from the first optical waveguide (21a), and is connected to the reflection element (24). The first optical waveguide (21a) and the second optical waveguide (23a) are coupled to the micro-ring optical waveguide (25a).

FIG. 3

**Description**

This application claims priority to Chinese Patent Application No. 202310311255.9, filed with the China National Intellectual Property Administration on March 14, 2023 and entitled "OPTICAL CHIP, EXTERNAL CAVITY LASER, LASER MODULE, AND LASER SENSING SYSTEM", which is incorporated herein by reference in its entirety.

**TECHNICAL FIELD**

This application relates to the field of semiconductor laser technologies, and in particular, to an optical chip, an external cavity laser, a laser module, and a laser sensing system.

**BACKGROUND**

An external cavity laser is a new cavity formed by adding an external optical feedback element to a semiconductor laser, and this is an only technical path to implement a linewidth of the semiconductor laser less than or equal to 10 kHz at present. According to different external cavity structures, external cavity lasers mainly include a discrete Fabry-Perot (Fabry-Perot) external cavity laser, a discrete external cavity fiber laser, an integrated grating external cavity laser, and an integrated micro-ring external cavity laser.

Table 1 Comparison between performance of different external cavity lasers

| External cavity structure | Linewidth | Size | Costs | Fast frequency modulation | Stability |
|---|---|---|---|---|---|
| Discrete Fabry-Perot external cavity | kHz | Medium | Medium | No | A feedback control circuit and an algorithm are required to implement passive frequency stabilization. The external cavity has average stability, and is susceptible to vibration interference. |
| Discrete fiber external cavity | 100 Hz | Large | High | No | |
| Integrated grating external cavity | kHz | Medium | Low | No | Self-injection locking and active frequency stabilization can be implemented. The external cavity has excellent stability, and is anti-vibration. |
| Integrated micro-ring external cavity | Hz to 100 Hz | Small | Low | Yes | |

It can be learned from the foregoing table that the integrated micro-ring external cavity structure has advantages such as an extremely narrow linewidth, a miniaturization, low costs, fast frequency modulation, and high stability.

However, with continuous expansion of application fields of the semiconductor laser, requirements for a linewidth and stability of the external cavity laser are increasingly high. In an existing integrated micro-ring laser, self-injection locking power reflected back to a gain chip from a micro-ring external cavity is low, and some external cavity reflection structures have process deviations, resulting in frequency drift of reflected light. This is not conducive to implementation of self-injection locking, and results in a limited linewidth narrowing effect.

**SUMMARY**

Embodiments of this application provide an optical chip, an external cavity laser, a laser module, and a laser sensing system, to resolve a problem of low self-injection locking optical power reflected back to a gain chip from a micro-ring external cavity in an existing integrated micro-ring laser.

To achieve the foregoing objective, the following technical solutions are used in this application.

According to a first aspect, an embodiment of this application provides an optical chip. The optical chip may be used as an external cavity chip of an external cavity laser. The optical chip is configured to receive light emitted by a gain chip in the laser. The optical chip includes a substrate and a waveguide layer disposed on the substrate. A first optical waveguide, a bidirectional power splitting optical waveguide, a second optical waveguide, a reflective optical waveguide, and a micro-ring optical waveguide are formed on the waveguide layer. The bidirectional power splitting optical waveguide has a first port, a second port, and a third port. A first end of the first optical waveguide is configured to be coupled to or connected to an end face of the gain chip in the laser; and a second end of the first optical waveguide is connected to the first port of the bidirectional power splitting optical waveguide. The micro-ring optical waveguide is located on a side of the first optical waveguide. One end of the second optical waveguide is connected to the second port of the bidirectional power splitting optical waveguide; the third port of the bidirectional power splitting optical waveguide is a light output port; and the other end of the second optical waveguide extends to another side that is of the micro-ring optical waveguide and that is away from the first optical waveguide, and is connected to the reflective optical waveguide. The first optical waveguide and the second optical waveguide are coupled to the micro-ring optical waveguide.

The first optical waveguide is configured to: couple, to the micro-ring optical waveguide, the light emitted by the gain chip; receive the light that is coupled after the micro-ring optical waveguide performs resonating, transmit a part of the light to the first port of the bidirectional power splitting optical waveguide, and transmit the other part of the light to the first end of the first optical waveguide; and transmit, to the first end of the first optical waveguide, light output from the first port of the bidirectional power splitting optical waveguide. The bidirectional power splitting optical waveguide is configured to: split the light input from the first port for output through the second port and the third port; and output, to the first port, the light input from the second port. The second optical waveguide is configured to: couple, to the micro-ring optical waveguide, a part of light output from the second port of the bidirectional power splitting optical waveguide, and transmit the other part of the light to the reflective optical waveguide; and transmit, to the second port of the bidirectional power splitting optical waveguide, a part of the light reflected back from the reflective optical waveguide, and couple the other part of the light to the micro-ring optical waveguide. The reflective optical waveguide is configured to reflect, back to the second optical waveguide, the light emitted from the second optical wave. The micro-ring optical waveguide is configured to: resonate the light coupled from the first optical waveguide and the light coupled from the second optical waveguide, and couple light to the first optical waveguide.

Therefore, a plurality of light output paths and a plurality of light return (return is returning to the gain chip in the laser) paths may be formed in the external cavity chip. The plurality of light output paths include a first light output path, a second output path, a third output path, a fourth output path, ..., an $N^{th}$ output path, and the like. The plurality of light return paths include a first light return path, a second light return path, a third light return path, a fourth light return path, ..., an $M^{th}$ light return path, and the like. The first light output path is as follows: The light emitted by the gain chip is transmitted in a first direction through the first optical waveguide, and is coupled to the micro-ring optical waveguide; the micro-ring optical waveguide resonates the light, and then couples the resonated light back to the first optical waveguide; then, the light continues to be transmitted in the first optical waveguide in the first direction, and enters the bidirectional power splitting optical waveguide through the first port; the bidirectional power splitting optical waveguide performs power splitting on the light to obtain first sub-light and second sub-light; and the first sub-light is directly output from the third port. The first light return path is as follows: The second sub-light obtained by the bidirectional power splitting optical waveguide through power splitting is output to the second optical waveguide through the second port; during transmission in a second direction through the second optical waveguide, a part of the second sub-light is coupled to the micro-ring optical waveguide for resonating; and the resonated light is coupled to the first optical waveguide and transmitted to the gain chip in a third direction, to implement self-injection locking. The first direction is opposite to the third direction. The second light return path is as follows: The other part of the second sub-light is transmitted to the reflective optical waveguide during transmission in the second direction through the second optical waveguide; and the reflective optical waveguide may reflect the light back to the second optical waveguide, and the light is transmitted in a fourth direction, where the second direction is opposite to the fourth direction; then, a part of the light transmitted in the second optical waveguide in the fourth direction enters the bidirectional power splitting optical waveguide through the second port, then enters the first optical waveguide through the first port, and is transmitted back to the gain chip in the third direction, to implement self-injection locking again. The second output path is as follows: The other part of the light transmitted in the second optical waveguide in the fourth direction is coupled to the micro-ring optical waveguide for resonating; the resonated light is coupled to the first optical waveguide and transmitted in the first direction, and enters the bidirectional power splitting optical waveguide through the first port; the bidirectional power splitting optical waveguide performs power splitting to obtain third sub-light and fourth sub-light; and the third sub-light is directly output from the third port. According to the foregoing description, similarly, the fourth sub-light may enter the second optical waveguide again, and is similar to the second sub-light, to form the third light return path (the same as a path of the first light return path), the fourth light return path (the same as a path of the second light return path), and the third output path (the second output path). In addition, light that is in the third output path and that enters the bidirectional power splitting optical waveguide may be further split into fifth sub-light and sixth sub-light, and the fifth sub-light is directly output from the third port. The sixth sub-light may continue the foregoing cycle, and the cycle repeats. Therefore, a plurality of light return paths are formed in the optical chip in this example, to feed more light back to the gain chip, so that power $P_r$ fed back to the semiconductor laser chip from the micro-ring external cavity is increased, a linewidth narrowing coefficient $\eta$ is increased, and a linewidth of the external cavity laser is narrowed. In addition, a plurality of output paths are also formed in the optical chip in this example, to increase output optical power. In addition, a structure of the optical chip in this example is simple.

Based on the foregoing structure of the optical chip, the first optical waveguide is a straight waveguide. The second optical waveguide includes two or more straight waveguides and two or more waveguide corners; all the waveguide corners sequentially connect the two or more straight waveguides, and connect the straight waveguide to a second port of the micro-ring optical waveguide; and one straight waveguide that is in the second optical waveguide and that is connected to the reflective optical waveguide is parallel to the first optical waveguide. Both the first optical waveguide and the second optical waveguide have simple structures, and are convenient to manufacture.

In addition, the reflective optical waveguide includes any one of a grating, a Sagnac ring, and a loop mirror. The loop mirror has an advantage of a large spectrum width, has a low optical power loss during light reflection, and does not introduce a frequency deviation caused by a process error. In this way, both a linewidth narrowing effect of the external cavity laser and stability of the laser are good, and a loss of lock does not occur.

In some embodiments, the bidirectional power splitting optical waveguide is any one of a multimode interferometer, a Y-shaped power splitter, and a directional coupler. Therefore, the bidirectional power splitting optical waveguide has an advantage of a large spectrum width, has a low optical power loss during power splitting and transmission, and does not introduce a frequency deviation caused by a process error. In this way, both a linewidth narrowing effect of the external cavity laser and stability of the laser are good, and a loss of lock does not occur.

In some implementations of this application, the bidirectional power splitting optical waveguide includes any one of a thermo-optic multimode interferometer, an electro-optic multimode interferometer, a photo-elastic multimode interferometer, a thermo-optic Y-shaped power splitter, an electro-optic Y-shaped power splitter, a photo-elastic Y-shaped power splitter, a thermo-optic directional coupler, an electro-optic directional coupler, and a photo-elastic directional coupler. The bidirectional power splitting optical waveguide has an adjustable split ratio, and therefore can adapt to an application scenario in which the laser needs to have an adjustable split ratio.

In addition, in an embodiment, the optical chip further includes a frequency modulation structure, and the frequency modulation structure is disposed on the micro-ring optical waveguide. The frequency modulation structure may adjust a refractive index of the micro-ring optical waveguide, to adjust a resonance frequency of the micro-ring optical waveguide, so as to change an output frequency of the external cavity laser. Therefore, this is applicable to an application scenario in which the external cavity laser needs to have a frequency modulation function. The frequency modulation structure may perform frequency modulation on the micro-ring optical waveguide in a thermo-optic manner, an electro-optic manner, a photo-elastic manner, or another manner.

In addition, in some embodiments, the optical chip includes a plurality of micro-ring optical waveguides coupled to each other, and the plurality of micro-ring optical waveguides are all located between the first optical waveguide and the second optical waveguide, and have different diameters. Therefore, frequency modulation ranges of the plurality of micro-ring optical waveguides are different. The plurality of micro-ring optical waveguides include a first micro-ring optical waveguide and a second micro-ring optical waveguide that are coupled to each other, the first micro-ring optical waveguide is coupled to the first optical waveguide, and the second micro-ring optical waveguide is coupled to the second optical waveguide. The two micro-ring optical waveguides may form a vernier caliper effect. Therefore, the frequency modulation structure is disposed on either the first micro-ring optical waveguide or the second micro-ring optical waveguide, to extend a wavelength tuning range of the external cavity laser.

In addition, based on the foregoing descriptions, in some embodiments, the plurality of micro-ring optical waveguides further include one or more third micro-ring optical waveguides, and the third micro-ring optical waveguide is coupled to an adjacent micro-ring optical waveguide (which may be the first micro-ring optical waveguide, the second micro-ring optical waveguide, or another third micro-ring optical waveguide). Similarly, a wavelength tuning range of the external cavity laser is further extended.

According to a second aspect, an embodiment of this application provides an external cavity laser. The external cavity laser includes a gain chip configured to emit light, and a first light guide structure, a bidirectional power splitting element, a second light guide structure, a reflection element, and a micro-ring resonator that are disposed on a light outlet side of the gain chip. The first light guide structure, the bidirectional power splitting element, and the second light guide structure are sequentially disposed in a light outlet direction of the gain chip. The bidirectional power splitting element has a first port, a second port, and a third port. The first port faces the first light guide structure, the second port faces the second light guide structure, and the third port is a light outlet. The reflection element is located on a light outlet side of the second light guide structure. The micro-ring resonator is located between the first light guide structure and the second light guide structure, and is coupled to the first light guide structure and the second light guide structure.

The first light guide structure is configured to: couple, to the micro-ring resonator, the light emitted by the gain chip; receive the light that is coupled after the micro-ring resonator performs resonating, transmit a part of the light to the first port of the bidirectional power splitting element, and transmit the other part of the light to the gain chip; and transmit, to the gain chip, light output from the first port of the bidirectional power splitting element. The bidirectional power splitting element is configured to: split the light input from the first port for output through the second port and the third port; and output, to the first port, the light input from the second port. The second light guide structure is configured to: couple, to the micro-ring resonator, a part of light output from the second port of the bidirectional power splitting element, and transmit the other part of the light to the reflection element; and transmit, to the second port of the bidirectional power splitting element, a part of the light reflected back from the reflection element, and couple the other part of the light to the micro-ring resonator. The reflection element is configured to reflect, back to the second light guide structure, the light emitted by the second light guide structure. The micro-ring resonator is configured to resonate the light coupled from the first light guide structure and the light coupled from the second light guide structure, and couple light to the first light guide structure.

Therefore, similarly, a plurality of light output paths and a plurality of light return (return is returning to a semiconductor laser chip) paths may be formed in the external cavity structure. The plurality of light output paths include a first light output path, a second output path, a third output path, a fourth output path, ..., an $N^{th}$ output path, and the like. The plurality of light return paths include a first light return path, a second light return path, a third light return path, a fourth light return path, ..., an $M^{th}$ light return path, and the like.

The first light output path is as follows: The light emitted by the gain chip is transmitted through the first light guide structure in a first direction and coupled to the micro-ring resonator; the micro-ring resonator resonates the light, and then couples the resonated light back to the first light guide structure; then, the light continues to be transmitted in the first light guide structure in the first direction, and enters the bidirectional power splitting element through the first port; the bidirectional power splitting element performs power splitting on the light to obtain first sub-light and second sub-light; and the first sub-light is directly output from the third port.

The first light return path is as follows: The second sub-light obtained by the bidirectional power splitting element through power splitting is output to the second light guide structure through the second port; during transmission in a second direction through the second light guide structure, a part of the second sub-light is coupled to the micro-ring resonator for resonating; and the resonated light is coupled to the first light guide structure and transmitted to the gain chip in a third direction, to implement self-injection locking. The first direction is opposite to the third direction.

The second light return path is as follows: The other part of the second sub-light is transmitted to the reflection element during transmission in the second direction through the second light guide structure; the reflection element may reflect the light back to the second light guide structure, and the light is transmitted in a fourth direction; and then, a part of the light transmitted in the second light guide structure in the fourth direction enters the bidirectional power splitting element through the second port, then enters the first light guide structure through the first port, and is transmitted back to the gain chip in the third direction, to implement self-injection locking again. The second direction is opposite to the fourth direction.

The second output path is as follows: The other part of the light transmitted in the second light guide structure in the fourth direction is coupled to the micro-ring resonator for resonating; the resonated light is coupled to the first light guide structure and transmitted in the first direction, and enters the bidirectional power splitting element through the first port; the bidirectional power splitting element performs power splitting to obtain third sub-light and fourth sub-light; and the third sub-light is directly output from the third port.

According to the foregoing description, similarly, the fourth sub-light may enter the second light guide structure again, and is similar to the second sub-light, to form the third light return path (the same as a path of the first light return path), the fourth light return path (the same as a path of the second light return path), and the third output path (the second output path). In addition, light that is in the third output path and that enters the bidirectional power splitting element may be further split into fifth sub-light and sixth sub-light, and the fifth sub-light is directly output from the third port. The sixth sub-light may continue the foregoing cycle, and the cycle repeats. Therefore, a plurality of light return paths are formed in the external cavity structure in this embodiment of this application, to feed more light back to the gain chip, so that power $P_r$ fed back to the semiconductor laser chip from the micro-ring external cavity is increased. The power $P_r$ fed back to the semiconductor laser chip from the micro-ring external cavity is directly proportional to a linewidth narrowing coefficient $\eta$. Therefore, the external cavity laser in this embodiment of this application increases the power $P_r$ fed back to the semiconductor laser chip from the micro-ring external cavity, so that the linewidth narrowing coefficient $\eta$ is increased, and a linewidth of the external cavity laser is narrowed.

In addition, in an embodiment, the optical chip further includes a frequency modulation structure, and the frequency modulation structure is disposed on the micro-ring resonator. The frequency modulation structure may adjust a refractive index of the micro-ring resonator, to adjust a resonance frequency of the micro-ring optical waveguide, so as to change an output frequency of the external cavity laser. Therefore, this is applicable to an application scenario in which the external cavity laser needs to have a frequency modulation function. The frequency modulation structure may perform frequency modulation on the micro-ring resonator in a thermo-optic manner, an electro-optic manner, a photo-elastic manner, or another manner.

In an embodiment, the external cavity laser further includes an external cavity chip, and the external cavity chip is disposed on the light outlet side of the gain chip. The external cavity chip includes a substrate and a waveguide layer disposed on the substrate. The first light guide structure, the bidirectional power splitting element, the second light guide structure, the reflection element, and the micro-ring resonator are all on a same layer and made of a same material, and are all formed on the waveguide layer of the external cavity chip. The external cavity structure is simple, and is convenient to process and manufacture by using an existing semiconductor manufacturing procedure.

Based on the foregoing descriptions, in some embodiments, the micro-ring resonator is a micro-ring optical waveguide. The first light guide structure is a straight waveguide. The first light guide structure is coupled to an end face of an optical port of the gain chip. The second light guide structure includes at least two straight waveguides and at least two waveguide corners; and the at least two waveguide corners respectively connect two adjacent straight waveguides in the at least two straight waveguides, and connect the straight waveguide to the second port of the micro-ring resonator. One end of the first light guide structure is coupled to or connected to an end face of the gain chip, and the other end of the first light guide structure is connected to the first port of the bidirectional power splitting element. Two ends of the second light guide structure are respectively connected to the second port of the bidirectional power splitting element and the reflection element. In addition, a straight waveguide that is in the second light guide structure and that is connected to the reflection element is parallel to the first light guide structure. The second light guide structure is connected to the reflection element. The first light guide structure and the second light guide structure are simple, and are convenient to manufacture.

In addition, the reflection element includes any one of a grating, a Sagnac ring, and a loop mirror. The loop mirror has an advantage of a large spectrum width, has a low optical power loss during light reflection, and does not introduce a frequency deviation caused by a process error. In this way, both a linewidth narrowing effect of the external cavity laser and stability of the laser are good, and a loss of lock does not occur.

In some embodiments, the bidirectional power splitting element is any one of a multimode interferometer (multimode interferometer, MMI), a Y-shaped power splitter, and a directional coupler (directional coupler, DC). The bidirectional power splitting element has an advantage of a large spectrum width, has a low optical power loss during power splitting and transmission, and does not introduce a frequency deviation caused by a process error. In this way, both a linewidth narrowing effect of the external cavity laser and stability of the laser are good, and a loss of lock does not occur.

In some implementations of this application, the bidirectional power splitting element includes any one of a thermo-optic multimode interferometer, an electro-optic multimode interferometer, a photo-elastic multimode interferometer, a thermo-optic Y-shaped power splitter, an electro-optic Y-shaped power splitter, a photo-elastic Y-shaped power splitter, a thermo-optic directional coupler, an electro-optic directional coupler, and a photo-elastic directional coupler. The bidirectional power splitting element has an adjustable split ratio, and therefore can adapt to an application scenario in which the laser needs to have an adjustable split ratio.

In addition, in some embodiments, the optical chip includes a plurality of micro-ring resonators coupled to each other, and the plurality of micro-ring resonators are all located between the first light guide structure and the second light guide structure, and have different diameters. Therefore, frequency modulation ranges of the plurality of micro-ring resonators are different. The plurality of micro-ring resonators include a first micro-ring resonator and a second micro-ring resonator that are coupled to each other, the first micro-ring resonator is coupled to the first light guide structure, and the second micro-ring resonator is coupled to the second light guide structure. The two micro-ring resonators may form a vernier caliper effect. Therefore, the frequency modulation structure is disposed on either the first micro-ring resonator and the second micro-ring resonator, to extend a wavelength tuning range of the external cavity laser.

In addition, based on the foregoing descriptions, in some embodiments, the plurality of micro-ring resonators further include one or more third micro-ring resonators, and the third micro-ring resonator is coupled to an adjacent micro-ring resonator (which may be the first micro-ring resonator, the second micro-ring resonator, or another third micro-ring resonator). Similarly, the frequency modulation structure is disposed on any one or more of the plurality of micro-ring resonators, to further extend the wavelength tuning range of the external cavity laser.

In some other embodiments, the first light guide structure includes a collimation lens and a first coupling mirror that are sequentially disposed in a light outlet direction of the gain chip. The micro-ring resonator is a micro-ring crystal cavity, and is located on a side of the first coupling mirror. The bidirectional power splitting element is a light splitter, the first port is a surface that is of the light splitter and that is on a light outlet path of the first coupling mirror, and the second port and the third port are respectively other two surfaces of the light splitter. The second light guide structure includes three or more total reflectors (referred to as a plurality of total reflectors below) and a second coupling mirror. One of the plurality of total reflectors is located on a light outlet path of the second port of the light splitter, and the plurality of total reflectors are sequentially disposed in a light path. The second coupling mirror is located on a side that is of the micro-ring resonator and that is away from the first coupling mirror, and is located on an emergent light path of the plurality of total reflectors. The reflection element is a total reflector. The reflection element is located on a light outlet path of the second coupling mirror. In this solution, the external cavity laser may be a micro-ring crystal cavity with a large quality factor Q. For example, the quality factor Q of the micro-ring crystal cavity is greater than $10^8$, to further improve linewidth narrowing performance.

According to a third aspect, an embodiment of this application provides a laser module. The laser module includes a temperature controller and the external cavity laser in the foregoing embodiment, and the temperature controller is in contact with the external cavity laser. Because the external cavity laser in the laser module in this embodiment of this application has a same structure as the external cavity laser in the foregoing embodiment, the two can solve a same technical problem and achieve a same technical effect. Details are not described herein again.

According to a fourth aspect, an embodiment of this application provides a distributed acoustic sensing system, including the laser module in the foregoing embodiment, a coupler, a pulse modulator, a circulator, an optical fiber, a coherent receiver, and a data processor. The coupler is configured to receive light emitted by the laser module and perform power splitting on the light, to output first sub-light and second sub-light. The pulse modulator is connected to the coupler, and is configured to convert the first sub-light output by the coupler into pulsed light. The circulator has a first interface, a second interface, and a third interface. The first interface is configured to receive the pulsed light output by the pulse modulator and transmit the pulsed light to the second interface. The optical fiber is disposed on a to-be-detected target, and is connected to the second interface of the circulator. The second interface is configured to: receive the pulsed light output from the first interface, and transmit the pulsed light to the optical fiber; and receive scattered light (the scattered light may be Rayleigh scattered light, Raman scattered light, or Brillouin scattered light) reflected back from the optical fiber, and transmit the scattered light to the third interface. The coherent receiver is connected to the third interface of the circulator and the coupler. The coherent receiver is configured to receive the scattered light output from the third interface of the circulator and the second sub-light output by the coupler, and perform interference and demodulation. The data processor is connected to the coherent receiver, and is configured to perform data processing on a signal output by the coherent receiver. Because the laser module in the distributed acoustic sensing system in this embodiment of this application has a same structure as the laser module in the foregoing embodiment, the two can solve a same technical problem and achieve a same technical effect, and a detectable distance of the distributed acoustic sensing system can be long. Details are not described herein again.

In addition, in some embodiments, the distributed acoustic sensing system further includes a first erbium-doped fiber amplifier and a second erbium-doped fiber amplifier. The first erbium-doped fiber amplifier connects the pulse modulator to the first interface of the circulator, and is configured to amplify the pulsed light output by the pulse modulator. The second erbium-doped fiber amplifier connects the third interface of the circulator to the coherent receiver, and is configured to amplify the scattered light output from the third interface of the circulator. Therefore, the distributed acoustic sensing system is applicable to an application scenario in which optical power of the pulsed light is low and optical power of the scattered light is low.

According to a fifth aspect, an embodiment of this application provides a frequency modulated continuous wave lidar system, including the laser module in the foregoing embodiment, a coupler, a circulator, a coherent receiver, and a data processor. The coupler is configured to receive light emitted by the laser module and perform power splitting on the light, to output first sub-light and second sub-light. The circulator has a first interface, a second interface, and a third interface. The first interface is connected to the coupler, and is configured to receive the first sub-light output by the coupler. The second interface is configured to receive the first sub-light output from the first interface, transmit the first sub-light to a to-be-detected target, and receive reflected light from the to-be-detected target. The third interface is configured to receive the reflected light that is from the to-be-detected target and that is output from the second interface. The coherent receiver is connected to the third interface of the circulator and the coupler, and is configured to receive the reflected light output from the third interface of the circulator and the second sub-light output by the coupler, and perform interference and demodulation. The data processor is connected to the coherent receiver, and is configured to perform data processing on a signal output by the coherent receiver. Because the laser module in the frequency modulated continuous wave lidar system in this embodiment of this application has a same structure as the laser module in the foregoing embodiment, the two can solve a same technical problem and achieve a same technical effect, and a detectable distance of the distributed acoustic sensing system can be long. Details are not described herein again.

According to a sixth aspect, an embodiment of this application provides a laser sensing system. The laser sensing system includes the laser module in the foregoing embodiment, a coupler, a coherent receiver, and a data processor. The coupler is configured to receive light emitted by the laser module and perform power splitting on the light, to output first sub-light and second sub-light. The coherent receiver is configured to: receive the second sub-light output by the coupler and target light that is formed after the first sub-light output by the coupler is transmitted to a to-be-detected target and then returns; and perform interference and demodulation. The data processor is connected to the coherent receiver, and is configured to perform data processing on a signal output by the coherent receiver. Because the laser module in the laser sensing system in this embodiment of this application has a same structure as the laser module in the foregoing embodiment, the two can solve a same technical problem and achieve a same technical effect, and a detectable distance or a detection distance of the laser sensing system can be long. Details are not described herein again.

## BRIEF DESCRIPTION OF DRAWINGS

To describe technical solutions in embodiments of this application, the following describes accompanying drawings used in embodiments of this application.

FIG. 1 is a module connection diagram of a laser sensing system according to an embodiment of this application;
FIG. 2 is a diagram of modules of a laser module according to an embodiment of this application;
FIG. 3 is a diagram of an optical path of an external cavity laser in a laser sensing system according to an embodiment of this application;
FIG. 4 is a side view of an external cavity laser in a laser sensing system according to an embodiment of this application;

FIG. 5 is a diagram of an optical path of an external cavity laser in Example 1;

FIG. 6 is a diagram of a structure of a micro-ring optical waveguide and a frequency modulation structure in an external cavity laser in Example 1;

FIG. 7 is a diagram of a structure of an external cavity laser having a first micro-ring optical waveguide and a second micro-ring optical waveguide in Example 1;

FIG. 8 is a diagram of a structure of an external cavity laser having a first micro-ring optical waveguide, a second micro-ring optical waveguide, and a third micro-ring optical waveguide in Example 1;

FIG. 9 is a diagram of an optical path of an external cavity laser in Example 2;

FIG. 10 is a diagram of a structure of a micro-ring optical waveguide and a frequency modulation structure in an external cavity laser in Example 2;

FIG. 11 is a diagram of a structure of an external cavity laser having a grating in Example 2;

FIG. 12 is a module connection diagram of a frequency modulated continuous wave lidar system according to an embodiment of this application;

FIG. 13 is a module connection diagram of a distributed acoustic sensing system according to an embodiment of this application; and

FIG. 14 is a module connection diagram of a distributed acoustic sensing system having a first erbium-doped fiber amplifier and a second erbium-doped fiber amplifier according to an embodiment of this application.

Reference numerals:

1000. laser sensing system; 1001. frequency modulated continuous wave lidar system; 1002. Distributed acoustic sensing system; 100. laser module; 10. laser; 20. temperature controller; 101. external cavity laser; 1. semiconductor laser chip; 11. gain chip; 111. total reflection interface; 12. pump source; 2. external cavity structure; 2a. optical chip; 201. substrate; 202. waveguide layer; 21. first light guide structure; 21a. first optical waveguide; 211b. collimation lens; 212b. first coupling mirror; 22. bidirectional power splitting element; 22a. bidirectional power splitting optical waveguide; 221. first port; 222. second port; 223. third port; 22b. light splitter; 2201. first end face; 2202. second end face; 2203. third end face; 23. second light guide structure; 23a. second optical waveguide; 231a. straight waveguide; 232a. waveguide corner; 231b. total reflector; 2311b. first total reflector; 2312b. second total reflector; 2313b. third total reflector; 232b. second coupling mirror; 24. reflection element; 24a. reflective optical waveguide; 24b. fourth total reflector; 25. micro-ring resonator; 25a. micro-ring optical waveguide; 25b. micro-ring crystal cavity; 251a. first micro-ring optical waveguide; 252a. second micro-ring optical waveguide; 253a. third micro-ring optical waveguide; 26. frequency modulation structure; 27. grating; 200. coupler; 300. coherent receiver; 400. data processor; 500. circulator; 501. first interface; 502. second interface; 503. third interface; 600. pulse modulator; 700. optical fiber; 800. first erbium-doped fiber amplifier; and 900. second erbium-doped fiber amplifier.

## DESCRIPTION OF EMBODIMENTS

To make objectives, technical solutions, and advantages of this application clearer, the following further describes this application in detail with reference to accompanying drawings.

The terms "first" and "second" mentioned below are merely intended for a purpose of description, and shall not be understood as an indication or implication of relative importance or implicit indication of a quantity of indicated technical features. Therefore, a characteristic limited by "first", "second", or the like may explicitly or implicitly include one or more characteristics. In the descriptions of this application, unless otherwise stated, "a plurality of" means two or more than two.

In addition, in this application, orientation terms such as "up", "down", "left", "right", "horizontal", and "vertical" are defined relative to orientations in which components are schematically placed in the accompanying drawings. It should be understood that, these directional terms are relative concepts that are used for relative description and clarification, and may vary accordingly based on changes of the orientations in which the components are placed in the accompanying drawings.

In this application, unless otherwise specified and limited, the term "connection" should be understood in a broad sense. For example, the term "connection" may be a connection of a mechanical structure or a connection of a physical structure. For example, the connection may be a fixed connection, or may be a detachable connection, or may be an integrated connection, or may be a direct connection, or may be an indirect connection through an intermediate medium. The connection may alternatively be understood as physical contact and electrical conduction of components, or may be understood as a form in which different components in a line structure are connected to each other through a physical line that can transmit an electrical signal or an optical signal, such as a PCB copper foil, a conducting wire, or an optical fiber.

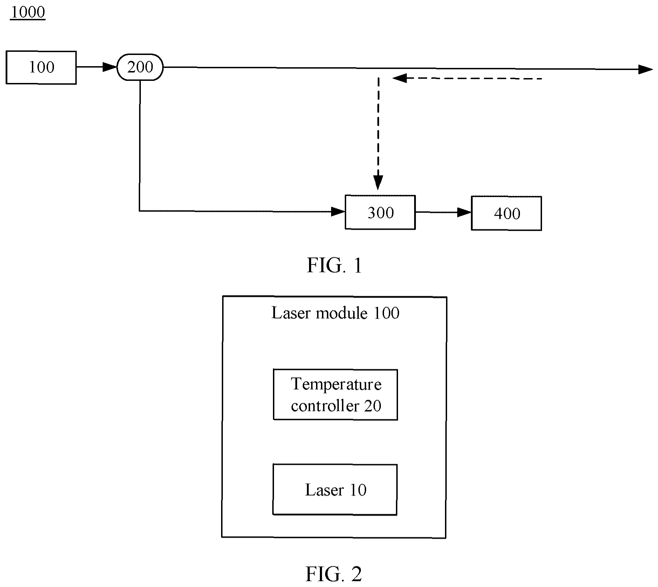

An embodiment of this application includes a laser sensing system 1000. As shown in FIG. 1, the laser sensing system 1000 includes a laser module 100, a coupler 200, a coherent receiver 300, and a data processor 400. The laser module 100 includes a laser 10 and a temperature controller 20 shown in FIG. 2. The laser 10 is configured to emit light. The light may be continuous wave (continuous wave, CW) light. The temperature controller 20 is in contact with the laser 10, to monitor and adjust a temperature of the laser 10, so that the laser 10 generates stably output laser light. In addition, the laser module 100 may further include another component. This is not limited in this application. The coupler 200 may be connected to the laser module 100, for example, through an optical fiber. The coupler 200 may receive light emitted by the laser 10 in the laser module 100, and perform power splitting on the light emitted by the laser 10. For example, the coupler 200 performs power splitting on the light emitted by the laser 10, and then outputs first sub-light and second sub-light. The first sub-light may be emitted to a to-be-detected target, and the to-be-detected target may be a person, a vehicle, a pipeline, or the like. The coherent receiver 300 may be connected to the coupler 200, for example, through an optical fiber. The coherent receiver 300 may receive the second sub-light output by the coupler 200 and target light formed after the first sub-light is emitted to the to-be-detected target and then is returned, and perform interference and demodulation on the second light and the target light. The data processor 400 is electrically connected to the coherent receiver 300, for example, through a conducting wire. The data processor 400 is configured to perform data processing on a signal output after interference and demodulation of the coherent receiver 300, to obtain information such as a location of the to-be-detected target (for example, a specific location at which a third-party intrusion event occurs in an oil and gas backbone pipeline network) and a speed of the to-be-detected target.

It should be noted that the laser sensing system 1000 may be specifically a frequency modulated continuous wave (frequency modulated continuous wave, FMCW) lidar system, a distributed acoustic sensing (distributed acoustic sensing, DAS) system, or the like. In addition, the laser sensing system 1000 may be further used in application scenarios such as temperature measurement and weight measurement of an optical frequency domain reflectometer (optical frequency domain reflectometry, OFDR). This is not limited in this application.

Regardless of the distributed acoustic sensing system or the frequency modulated continuous wave lidar system, the laser 10 determines key performance of the laser sensing system 1000. A detectable distance L of the distributed acoustic sensing system is limited to half of a coherence length $L_{coh}$ of the laser 10, that is, $L_{coh}/2$. $L_{coh}=c/\pi\Delta v$, where c is a speed of light. Therefore, the detectable distance of the distributed acoustic sensing system is determined based on a linewidth $\Delta v$ of the laser 10. For example, the distributed acoustic sensing system with a detectable distance of 50 km requires the laser 10 with a linewidth of about 1 kHz. A detectable distance L of the frequency modulated continuous wave lidar system is also limited to half of the coherence length $L_{coh}$ of the laser 10, that is, limited to the linewidth $\Delta v$ of the laser 10. For example, the frequency modulated continuous wave lidar system with a detectable distance of 300 m to 500 m requires the laser 10 with a linewidth of about 100 kHz to 150 kHz.

The linewidth $\Delta v$ of the laser 10 is mainly affected by phase noise caused by spontaneous radiation. To obtain a small linewidth, the laser 10 may be an external cavity laser. The external cavity laser is a new cavity formed by adding an external optical feedback element to a semiconductor laser chip 1. An external cavity structure can increase an overall cavity length, increase density of photons in the cavity, prolong service life of the photons in the cavity, and suppress spontaneous radiation, to narrow the linewidth. For example, the linewidth of the external cavity laser is less than or equal to 10 kHz.

A larger length of an external cavity indicates a smaller linewidth $\Delta v$ of the external cavity laser. However, this contradicts miniaturization of the laser. According to different external cavity structures, external cavities of external cavity lasers mainly include a discrete Fabry-Perot external cavity structure, a discrete fiber external cavity structure, an integrated grating external cavity structure, an integrated micro-ring external cavity structure, and the like. The external cavity laser in this embodiment of this application uses the integrated micro-ring external cavity structure, and therefore has advantages such as a small linewidth, a small size, low costs, fast frequency modulation, and high stability, and does not generate a loss of lock. In addition, the integrated micro-ring external cavity structure may further implement self-injection locking. However, in the external cavity laser, self-injection locking power reflected back to a gain chip from a micro-ring is low, and some external cavity reflection structures have process deviations, resulting in frequency drift of reflected light. This is not conducive to implementation of self-injection locking, and results in a limited linewidth narrowing effect.

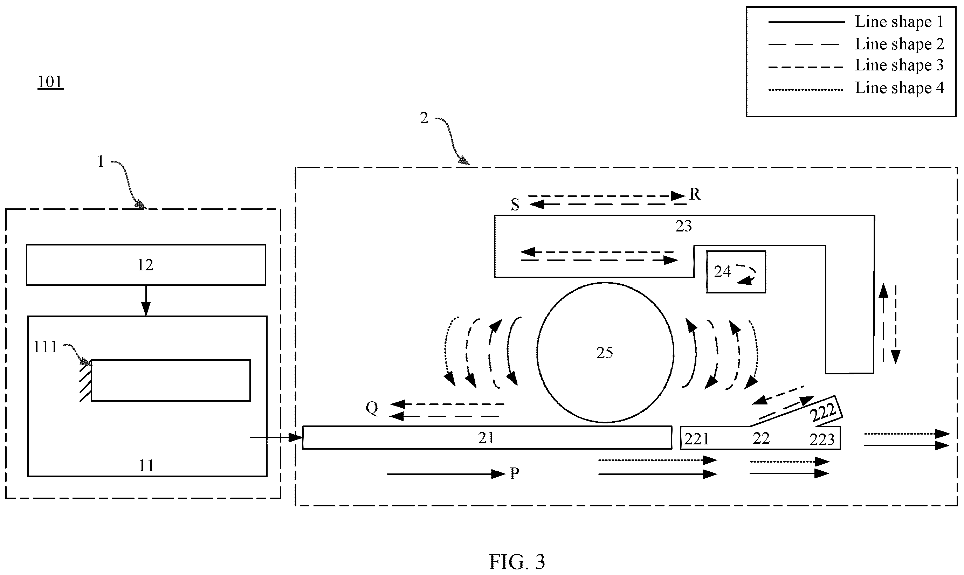

To further narrow the linewidth of the external cavity laser, as shown in FIG. 3, the external cavity laser 101 in this embodiment of this application includes the semiconductor laser chip 1 and an external cavity structure 2. The semiconductor laser chip 1 includes a gain chip 11, and the gain chip 11 is configured to emit light. The gain chip 11 is an integrated chip in which a functional layer (such as a waveguide layer) is made of a III-V group (such as gallium arsenide GaAs and indium phosphide InP) compound. In addition, the gain chip 11 includes but is not limited to a chip formed by a gain medium and a total reflection interface 111, a distributed feedback (distributed feedback, DFB) chip undergoing anti-reflection (anti-reflection, AR) end face processing, and a reflected semiconductor optical amplifier (reflected semiconductor optical amplifier, RSOA) chip. The semiconductor laser chip 1 may further include a pump source 12. The pump source 12 may provide electrical pumping or optical pumping for the gain chip 11, so that the gain chip 11 generates stimulated radiation and optical amplification.

The external cavity structure 2 is disposed on a light outlet side of the gain chip 11. The external cavity structure 2 includes a first light guide structure 21, a bidirectional power splitting element 22, a second light guide structure 23, a reflection element 24, and a micro-ring resonator 25. The first light guide structure 21, the bidirectional power splitting element 22, and the second light guide structure 23 are sequentially disposed in a light outlet direction of the gain chip 11. The bidirectional power splitting element 22 is an element that can perform light transmission in two mutually reversible directions, and power splitting can be implemented in one of the directions. The bidirectional power splitting element 22 has a first port 221, a second port 222, and a third port 223. The first port 221 faces the first light guide structure 21, the second port 222 faces the second light guide structure 23, and the third port 223 may be a light outlet. The reflection element 24 is located on a light outlet side of the second light guide structure 23. The micro-ring resonator 25 is located between the first light guide structure 21 and the second light guide structure 23. The micro-ring resonator 25 is coupled to the first light guide structure 21 and the second light guide structure 23. The first light guide structure 21 is configured to: couple, to the micro-ring resonator 25, the light emitted by the gain chip 11; receive the light that is coupled after the micro-ring resonator 25 performs resonating, transmit a part of the light to the first port 221 of the bidirectional power splitting element 22, and transmit the other part of the light to the gain chip 11; and transmit, to the gain chip 11, light output from the first port 221 of the bidirectional power splitting element 22. The bidirectional power splitting element 22 is configured to: split the light input from the first port 221 for output through the second port 222 and the third port 223; and output, to the first port 221, light input from the second port 222. The second light guide structure 23 is configured to: couple, to the micro-ring resonator 25, a part of light output from the second port 222 of the bidirectional power splitting element 22, and transmit the other part of the light to the reflection element 24; and transmit, to the second port 222 of the bidirectional power splitting element 22, a part of the light reflected back from the reflection element 24, and couple the other part of the light to the micro-ring resonator 25. The reflection element 24 is configured to reflect, back to the second light guide structure 23, the light emitted by the second light guide structure 23. The micro-ring resonator 25 is configured to resonate the light coupled from the first light guide structure 21 and the light coupled from the second light guide structure 23, and couple light to the first light guide structure 21.

Therefore, a plurality of light output paths and a plurality of light return (return is returning to the semiconductor laser chip 1) paths may be formed in the external cavity structure 2. The plurality of light output paths include a first light output path, a second output path, a third output path, a fourth output path, ..., an $N^{th}$ output path, and the like. The plurality of light return paths include a first light return path, a second light return path, a third light return path, a fourth light return path, ..., an $M^{th}$ light return path, and the like.

The first light output path (a path shown by arrows in a line shape 1 in FIG. 3) is as follows: The light emitted by the gain chip 11 is transmitted in a first direction P through the first light guide structure 21 and coupled to the micro-ring resonator 25; the micro-ring resonator 25 resonates the light, and then couples the resonated light back to the first light guide structure 21; then, the light continues to be transmitted along the first light guide structure 21, and enters the bidirectional power splitting element 22 through the first port 221; the bidirectional power splitting element 22 performs power splitting to obtain first sub-light and second sub-light; and the first sub-light is directly output from the third port 223.

The first light return path (a path shown by arrows in a line shape 2 in FIG. 3) is as follows: The second sub-light obtained by the bidirectional power splitting element 22 through power splitting is output to the second light guide structure 23 through the second port 222; during transmission in a second direction S through the second light guide structure 23, a part of the second sub-light is coupled to the micro-ring resonator 25 for resonating; and the resonated light is coupled to the first light guide structure 21 and transmitted to the gain chip 11 in a third direction Q, to implement self-injection locking. The first direction P is opposite to the third direction Q.

The second light return path (a path shown by arrows in a line shape 3 in FIG. 3) is as follows: The other part of the second sub-light is transmitted to the reflection element 24 during transmission in the second direction S through the second light guide structure 23; the reflection element 24 may reflect the light back to the second light guide structure 23, and the light is transmitted in a fourth direction R; and then, a part of the light transmitted in the second light guide structure 23 in the fourth direction R enters the bidirectional power splitting element 22 through the second port 222, then enters the first light guide structure 21 through the first port 221, and is transmitted back to the gain chip 11 in the third direction Q, to implement self-injection locking again. The second direction S is opposite to the fourth direction R.

The second output path (a path shown by arrows in a line shape 4 in FIG. 3) is as follows: The other part of the light transmitted in the second light guide structure 23 in the fourth direction R is coupled to the micro-ring resonator 25 for resonating; the resonated light is coupled to the first light guide structure 21 and transmitted in the first direction P, and enters the bidirectional power splitting element 22 through the first port 221; the bidirectional power splitting element 22 performs power splitting to obtain third sub-light and fourth sub-light; and the third sub-light is directly output from the third port 223.

According to the foregoing description, similarly, the fourth sub-light may enter the second light guide structure 23 again, and is similar to the second sub-light, to form the third light return path (the same as a path of the first light return path), the fourth light return path (the same as a path of the second light return path), and the third output path (the second output path). In addition, light that is in the third output path and that enters the bidirectional power splitting element 22 may be further split into fifth sub-light and sixth sub-light, and the fifth sub-light is directly output from the third port 223. The sixth sub-light may continue the foregoing cycle, and the cycle repeats. Therefore, a plurality of light return paths are formed in the external cavity structure 2 in this embodiment of this application, to feed more light back to the gain chip 11, so that power $P_r$ fed back to the semiconductor laser chip 1 from the micro-ring external cavity is increased. A formula for calculating a linewidth narrowing coefficient $\eta$ of the external cavity laser 101 is as follows:

$$\eta = 1 + \sqrt{\frac{P_r}{P}(1 + \alpha^2)\frac{Q}{Q_{LD}}}$$

$P_r$ is the power fed back to the semiconductor laser chip 1 in the external cavity laser 101 from the micro-ring external cavity in the external cavity laser 101, P is output optical power of the semiconductor laser chip 1, $\alpha$ is a linewidth broadening factor of the semiconductor laser chip 1, Q is a quality factor of the micro-ring external cavity, and $Q_{LD}$ is a quality factor of the semiconductor laser chip 1. It can be learned from the foregoing formula that the power $P_r$ fed back to the semiconductor laser chip 1 from the micro-ring external cavity is directly proportional to the linewidth narrowing coefficient $\eta$. Therefore, the external cavity laser 101 in this embodiment of this application increases the power $P_r$ fed back to the semiconductor laser chip 1 from the micro-ring external cavity, so that the linewidth narrowing coefficient $\eta$ is increased, and the linewidth of the external cavity laser 101 is narrowed.

Based on the structure of the external cavity laser 101, the external cavity structure 2 may be a chip, or may include a discrete component. This is not limited in this application. The following further describes this application with reference to two specific embodiments.

**Example 1**

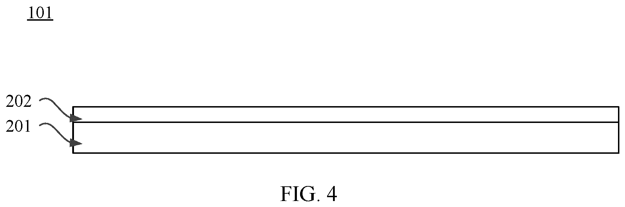

As shown in FIG. 4, in this example, the external cavity structure 2 in the external cavity laser 101 is an optical chip 2a, which may also be referred to as an external cavity chip. The optical chip 2a may be coupled to an end face of the gain chip 11, or may be integrated with the gain chip 11 in a manner like heterogeneous bonding or epitaxial growth. Therefore, the optical chip 2a is disposed on a light outlet path of the gain chip 11. The optical chip 2a includes a substrate 201 and a waveguide layer 202 disposed on the substrate 201. The first light guide structure 21, the bidirectional power splitting element 22, the second light guide structure 23, the reflection element 24, and the micro-ring resonator 25 are all formed on the waveguide layer 202. Therefore, the first light guide structure 21, the bidirectional power splitting element 22, the second light guide structure 23, the reflection element 24, and the micro-ring resonator 25 are all on a same layer and made of a same material, and can use a same single patterning process.

It should be noted that, the "same layer" is a layer structure formed by using a same mask and a single patterning process after a film for forming specific patterns is formed by using a same film forming process. Based on different specific patterns, a same patterning process may include a plurality of times of exposure, development, or etching processes. Moreover, the specific patterns in the formed layer structure may be consecutive or inconsecutive, and these specific patterns may also be at different heights or have different thicknesses. The single patterning process in this example is described by using an example in which different exposure regions are formed by using a single mask exposure process, and then removal processes such as etching and ashing are performed on the different exposure regions for a plurality of times to finally obtain an expected pattern.

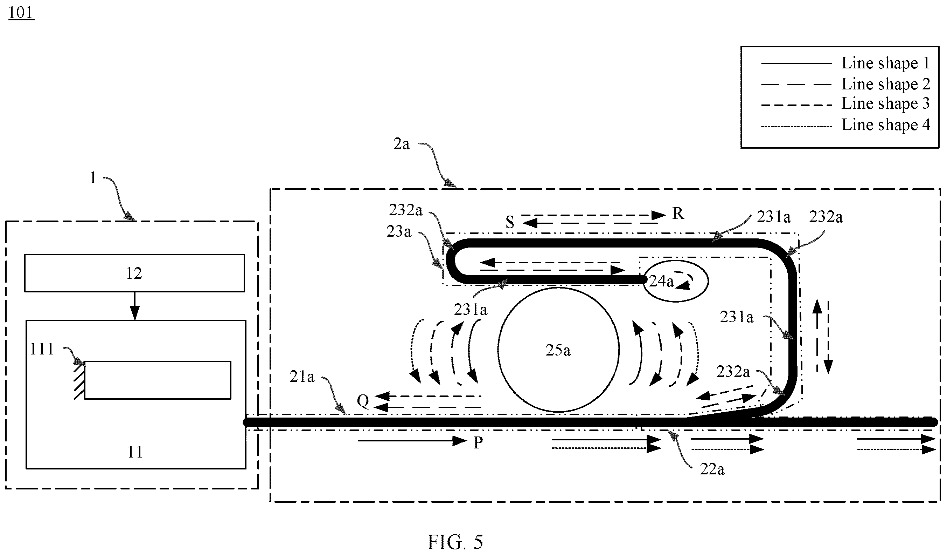

Therefore, as shown in FIG. 3 and FIG. 5, the first light guide structure 21 is a first optical waveguide 21a, and the second light guide structure 23 is a second optical waveguide 23a. The bidirectional power splitting element 22 is a bidirectional power splitting optical waveguide 22a. The bidirectional power splitting optical waveguide 22a is an element that can perform light transmission in two mutually reversible directions, and power splitting can be implemented in one of the directions. The micro-ring resonator 25 is a micro-ring optical waveguide 25a, and the reflection element 24 is a reflective optical waveguide 24a. The first port 221, the second port 222, and the third port 223 of the bidirectional power splitting element 22 may be three different end faces of the bidirectional power splitting optical waveguide 22a.

A first end of the first optical waveguide 21a may be connected to an end face of the gain chip 11 in the external cavity laser 101, and a second end of the first optical waveguide 21a is connected to the first port 221 of the bidirectional power splitting element 22. The micro-ring optical waveguide 25a is located on a side of the first optical waveguide 21a. One end of the second optical waveguide 23a is connected to the second port 222 of the bidirectional power splitting element 22, and the other end of the second optical waveguide 23a extends to another side that is of the micro-ring optical waveguide 25a and that is away from the first optical waveguide 21a, and is connected to the reflection element 24. Therefore, the micro-ring optical waveguide 25a is located between the first optical waveguide 21a and the second optical waveguide 23a.

The first optical waveguide 21a may couple, to the micro-ring optical waveguide 25a, light emitted by the gain chip 11; receive light that is coupled after the micro-ring optical waveguide 25a performs resonating, transmit a part of the light to the first port 221 of the bidirectional power splitting optical waveguide 22a, and transmit the other part of the light to the first end; and transmit, to the second end, light output from the first port 221 of the bidirectional power splitting optical waveguide 22a.

The bidirectional power splitting optical waveguide 22a may split light input from the first port 221 for output through the second port 222 and the third port 223; and output, to the first port 221, light input from the second port 222.

The second optical waveguide 23a may couple, to the micro-ring optical waveguide 25a, a part of light output from the second port 222 of the bidirectional power splitting optical waveguide 22a, and transmit the other part of the light to the reflective optical waveguide 24a; and transmit, to the second port 222 of the bidirectional power splitting optical waveguide 22a, a part of the light reflected back from the reflective optical waveguide 24a, and couple the other part of the light to the micro-ring optical waveguide 25a.

The reflective optical waveguide 24a may reflect, back to the second optical waveguide 23a, light emitted from the second optical waveguide 23a. The micro-ring optical waveguide 25a is configured to resonate light coupled from the first optical waveguide 21a and light coupled from the second optical waveguide 23a, and couple light to the first optical waveguide 21a.

Therefore, a first light output path (a path shown by arrows in a line shape 1 in FIG. 5) formed in the optical chip 2a is as follows: The light emitted by the gain chip 11 is transmitted in a first direction P through the first optical waveguide 21a and coupled to the micro-ring optical waveguide 25a; the micro-ring optical waveguide 25a resonates the light, and then couples the resonated light back to the first optical waveguide 21a; then, the light continues to be transmitted along the first optical waveguide 21a, and enters the bidirectional power splitting optical waveguide 22a through the first port 221; the bidirectional power splitting optical waveguide 22a performs power splitting to obtain first sub-light and second sub-light; and the first sub-light is directly output from the third port 223.

A first light return path (a path shown by arrows in a line shape 2 in FIG. 5) is as follows: The second sub-light obtained by the bidirectional power splitting optical waveguide 22a through power splitting is output to the second optical waveguide 23a through the second port 222; during transmission in a second direction S through the second optical waveguide 23a, a part of the second sub-light is coupled to the micro-ring optical waveguide 25a for resonating; and the resonated light is coupled to the first optical waveguide 21a and transmitted to the gain chip 11 in a third direction Q, to implement self-injection locking.

A second light return path (a path shown by arrows in a line shape 3 in FIG. 5) is as follows: During transmission in the second direction S through the second optical waveguide 23a, the other part of the second sub-light is transmitted to the reflective optical waveguide 24a; the reflective optical waveguide 24a may reflect the light back to the second optical waveguide 23a, and transmit the light in a fourth direction R; and then, a part of the light transmitted in the second optical waveguide 23a in the fourth direction R enters the bidirectional power splitting optical waveguide 22a through the second port 222, then enters the first optical waveguide 21a through the first port 221, and is transmitted back to the gain chip 11 in the third direction Q, to implement self-injection locking again.

A second output path (a path shown by arrows in a line shape 4 in FIG. 5) is as follows: The other part of the light transmitted in the second optical waveguide 23a in the fourth direction R is coupled to the micro-ring optical waveguide 25a for resonating; the resonated light is coupled to the first optical waveguide 21a and transmitted in the first direction P, and enters the bidirectional power splitting optical waveguide 22a through the first port 221; the bidirectional power splitting optical waveguide 22a performs power splitting to obtain third sub-light and fourth sub-light; and the third sub-light is directly output from the third port 223.

According to the foregoing description, similarly, the fourth sub-light may enter the second optical waveguide 23a again, and is similar to the second sub-light, to form the third light return path (the same as a path of the first light return path), the fourth light return path (the same as a path of the second light return path), and the third output path (the second output path). In addition, light that is in the third output path and that enters the bidirectional power splitting optical waveguide 22a may be further split into fifth sub-light and sixth sub-light, and the fifth sub-light is directly output from the third port 223. The sixth sub-light may continue the foregoing cycle, and the cycle repeats.

Therefore, a plurality of light return paths in the optical chip 2a in this example, to feed more light back to the gain chip 11, so that power $P_r$ fed back to the semiconductor laser chip 1 from the micro-ring external cavity is increased, a linewidth narrowing coefficient $\eta$ is increased, and the linewidth of the external cavity laser 101 is narrowed. In addition, a plurality of output paths are also formed in the optical chip 2a in this example, to increase output optical power. In addition, a structure of the optical chip 2a in this example is simple.

Based on the foregoing descriptions, in some embodiments of this example, the first optical waveguide 21a may be a straight waveguide, the second optical waveguide 23a includes a straight waveguide 231a and a waveguide corner 232a, and there may be two or more straight waveguides 231a. The waveguide corner 232a is configured to connect two adjacent straight waveguides 231a, and may further connect the straight waveguide 231a to the second port 222 of the micro-ring optical waveguide 25a. Therefore, a proper quantity of waveguide corners 232a may be selected based on a quantity of straight waveguides 231a, and there are two or more waveguide corners 232a in the second optical waveguide 23a. The second optical waveguide 23a shown in FIG. 5 includes three straight waveguides 231a and three waveguide corners 232a, two waveguide corners 232a sequentially connect the three straight waveguides 231a, and the other waveguide corner 232a connects one straight waveguide 231a close to the bidirectional power splitting optical waveguide 22a to the second port 222 of the bidirectional power splitting optical waveguide 22a. In addition, one straight waveguide 231a that is in the second optical waveguide 23a and that is connected to the reflective optical waveguide 24a is parallel to the first optical waveguide 21a. The first optical waveguide 21a and the second optical waveguide 23a have simple structures, and are convenient to manufacture.

The reflection element 24 of the waveguide structure includes any one of a grating, a Sagnac ring, and a loop mirror. In some embodiments of this example, the reflection element 24 is a loop mirror. The loop mirror has an advantage of a large spectrum width, has a low optical power loss during light reflection, and does not introduce a frequency deviation caused by a process error. In this way, both a linewidth narrowing effect of the external cavity laser 101 and stability of the external cavity laser 101 are good, and a loss of lock does not occur.

In some embodiments, the bidirectional power splitting element 22 is any one of a multimode interferometer (multimode interferometer, MMI), a Y-shaped power splitter, and a directional coupler (directional coupler, DC). Therefore, the bidirectional power splitting element 22 has an advantage of a large spectrum width, has a low optical power loss during power splitting and transmission, and does not introduce a frequency deviation caused by a process error. In this way, both a linewidth narrowing effect of the external cavity laser 101 and stability of the external cavity laser 101 are good, and a loss of lock does not occur.

In addition, a split ratio of the bidirectional power splitting element 22 may be constant, to be specific, a ratio of the first sub-light to the second sub-light formed through power splitting on the light entering from the first port 221 is constant.

The split ratio of the bidirectional power splitting element 22 is adjustable. For example, split optical power of the bidirectional power splitting element 22 is adjustable based on a plurality of effects such as a thermo-optic effect, an electro-optic effect, and a photo-elastic effect. Therefore, in some embodiments, the bidirectional power splitting element 22 includes any one of a thermo-optic multimode interferometer, an electro-optic multimode interferometer, a photo-elastic multimode interferometer, a thermo-optic Y-shaped power splitter, an electro-optic Y-shaped power splitter, a photo-elastic Y-shaped power splitter, a thermo-optic directional coupler, an electro-optic directional coupler, and a photo-elastic directional coupler.

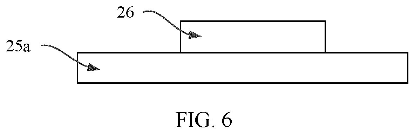

In addition, the optical chip 2a in this example further includes a frequency modulation structure 26 shown in FIG. 6, and the frequency modulation structure 26 is disposed on the micro-ring optical waveguide 25a. The frequency modulation structure 26 may adjust a refractive index of the micro-ring optical waveguide 25a, to adjust a resonance frequency of the micro-ring optical waveguide 25a, so as to change an output frequency of the external cavity laser 101. Therefore, this is applicable to an application scenario in which the external cavity laser 101 needs to have a frequency modulation function. For example, the frequency modulation structure 26 may be a frequency modulator made of titanium nitride, and the frequency modulator is disposed on the micro-ring optical waveguide 25a. The frequency modulator performs frequency modulation on the micro-ring optical waveguide 25a in a thermo-optic manner, an electro-optic manner, a photo-elastic manner, or another manner. In addition, a signal loaded by the frequency modulator onto the micro-ring optical waveguide 25a may be a triangular wave, a square wave, a sawtooth wave, or the like. This is not limited in this application.

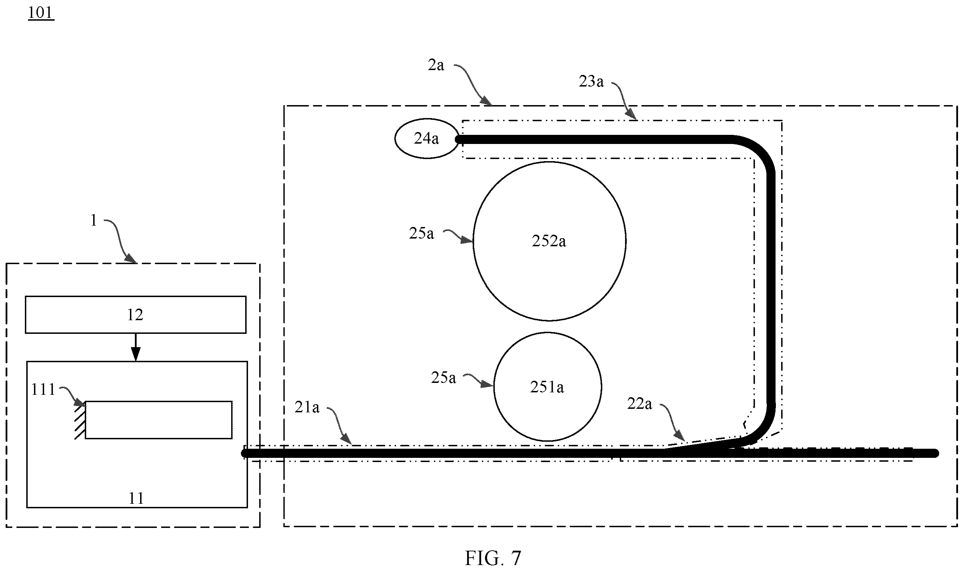

As shown in FIG. 7, the external cavity laser 101 in this example may include only one micro-ring optical waveguide 25a. The micro-ring optical waveguide 25a can perform frequency modulation only within a specific range. A larger radius of the micro-ring optical waveguide 25a indicates a smaller frequency modulation range. Therefore, this solution is applicable only to an application scenario of a small frequency modulation range.

Due to a limitation of a chip processing process (for example, a chip processing process in which silicon nitride $Si_3N_4$ is used as a waveguide layer material), a radius of the micro-ring optical waveguide 25a cannot be excessively small. Otherwise, a large loss is caused, a Q value of the micro-ring optical waveguide 25a is low, and performance of a small linewidth cannot be achieved. Therefore, in some embodiments of this application, as shown in FIG. 7, the optical chip 2a includes a plurality of micro-ring optical waveguides 25a that are coupled to each other, the plurality of micro-ring optical waveguides 25a are all located between the first optical waveguide 21a and the second optical waveguide 23a, and diameters of the plurality of micro-ring optical waveguides 25a are different. Therefore, frequency modulation ranges of the plurality of micro-ring optical waveguides 25a are different. It should be noted that the plurality of micro-ring optical waveguides 25a may be an odd number of micro-ring optical waveguides or an even number of micro-ring optical waveguides. This is not limited in this application.

As shown in FIG. 7, the plurality of micro-ring optical waveguides 25a include a first micro-ring optical waveguide 251a and a second micro-ring optical waveguide 252a that are coupled to each other, the first micro-ring optical waveguide 251a is coupled to the first optical waveguide 21a, and the second micro-ring optical waveguide 252a is coupled to the second optical waveguide 22a. The two micro-ring optical waveguides 25a may form a vernier caliper effect. For example, a frequency modulation range of the first micro-ring optical waveguide 251a is $f_1$, and a frequency modulation range of the second micro-ring optical waveguide 252a is $f_2$. Therefore, a frequency modulation range of the external cavity laser 101 is a least common multiple of $f_1$ and $f_2$. Therefore, the frequency modulation structure 26 is disposed on either the first micro-ring optical waveguide 251a or the second micro-ring optical waveguide 252a, to extend a wavelength tuning range of the external cavity laser 101.

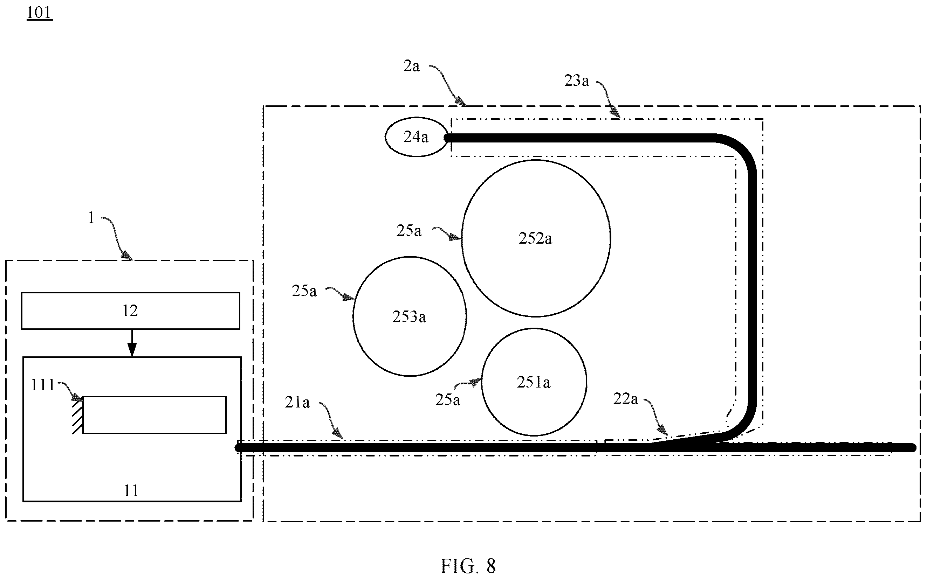

In addition, in some embodiments, the plurality of micro-ring optical waveguides 25a further include one or more third micro-ring optical waveguides 253a shown in FIG. 8. The one or more third micro-ring optical waveguides 253a may be coupled to an adjacent micro-ring optical waveguide 25a (for example, the first micro-ring optical waveguide 251a, the second micro-ring optical waveguide 252a, or another adjacent third micro-ring optical waveguide 253a). Similarly, the frequency modulation structure 26 is disposed on any one or more of the plurality of micro-ring optical waveguides 25a, to further extend the wavelength tuning range of the external cavity laser 101.

**Example 2**

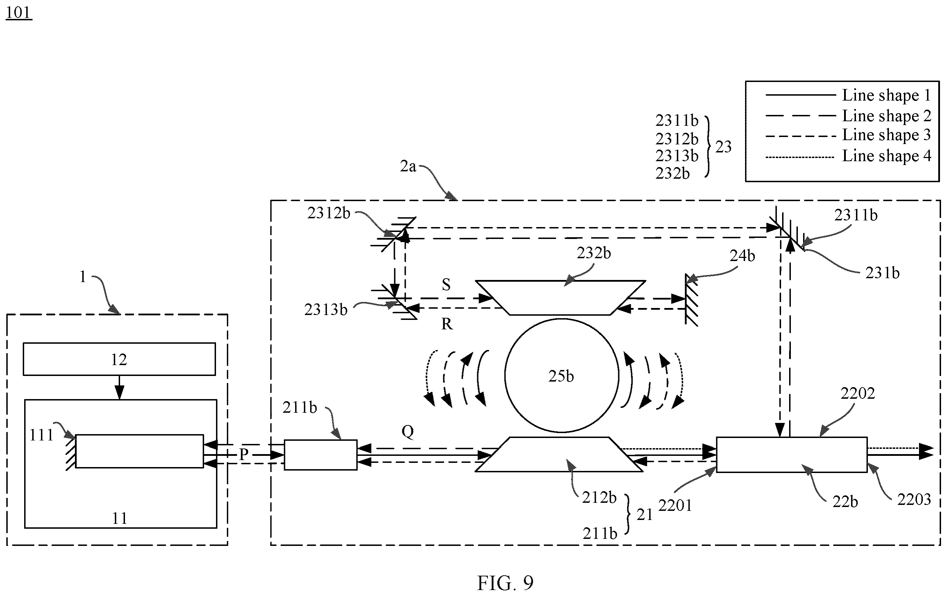

As shown in FIG. 9, each component in the external cavity structure 2 of the external cavity laser 101 in this example may be a discrete component. The first light guide structure 21 includes a collimation lens 211b and a first coupling mirror 212b. There may be one, two, or more collimation lenses 211b. This is not limited in this application. All collimation lenses 211b are configured to collimate output light of the gain chip 11, that is, convert the output light into parallel light. The first coupling mirror 212b may be specifically a coupling prism. The one or more collimation lenses 211b and the first coupling mirror 212b are sequentially disposed in a light outlet direction of the gain chip 11. The first light guide structure 21 shown in FIG. 9 includes only one collimation lens 211b and one first coupling mirror 212b.

The micro-ring resonator 25 is a micro-ring crystal cavity 25b. The micro-ring resonator 25 is located on an end face of a side of the first coupling mirror 212b, so that the micro-ring resonator 25 can be coupled to the first coupling mirror 212b.

The bidirectional power splitting element 22 is a light splitter 22b. Therefore, the first port 221, the second port 222, and the third port 223 of the bidirectional power splitting element 22 may be different light outlet surfaces of the light splitter 22b. To be specific, the first port 221 is a first end face 2201 that is of the light splitter 22b and that is located on a light outlet path of the first coupling mirror 212b, the second port 222 is a second end face 2202 of the light splitter 22b, and the third port 223 is a third end face 2203 of the light splitter 22b. The light splitter 22b may be specifically a light splitting prism.

The second light guide structure 23 includes total reflectors 231b and a second coupling mirror 232b shown in FIG. 9. There may be four or more total reflectors 231b. This is not limited in this application. One total reflector 231b is located on a light outlet path of the second port 222 of the light splitter 22b. The second coupling mirror 232b is located on a side that is of the micro-ring resonator 25 and that is away from the first coupling mirror 212b, and is located on a light outlet path of another total reflector 231b. Therefore, the second coupling mirror 232b may be coupled to the micro-ring crystal cavity 25b.

The reflection element 24 is the total reflector 231b, and the reflection element 24 is located on a light outlet path of the second coupling mirror 232b. Therefore, light output by the second coupling mirror 232b can be transmitted to the reflection element 24. In addition, the reflection element 24 can further reflect light back to the second coupling mirror 232b.

The second light guide structure 23 shown in FIG. 9 includes three total reflectors 231b, and the three total reflectors 231b are respectively a first total reflector 2311b, a second total reflector 2312b, and a third total reflector 2313b. The reflection element 24 is a fourth total reflector 24b. The first total reflector 2311b is located on the light outlet path of the second end face 2202 of the light splitter 22b. The first total reflector 2311b, the second total reflector 2312b, the third total reflector 2313b, and the fourth total reflector 24b are sequentially disposed along a light path. The second coupling mirror 232b is located on a light path from the third total reflector 2313b to the fourth total reflector 24b and a light path from the fourth total reflector 24b to the third total reflector 2313b.

The external cavity laser 101 shown in FIG. 9 is used as an example. A first light output path (a path shown by arrows in a line shape 1 in FIG. 9) formed in the optical chip 2a is as follows: The light emitted by the gain chip 11 is sequentially transmitted and coupled to the micro-ring crystal cavity 25b through the one or more collimation lenses 211b and the first coupling mirror 212b in a first direction P; the micro-ring crystal cavity 25b resonates the light, and couples the resonated light back to the first coupling mirror 212b, and the resonated light continues to be transmitted in the first direction P; then, the light is emitted from the first coupling mirror 212b to the first end face 2201, and enters the light splitter 22b through the first end face 2201; the light splitter 22b performs power splitting to obtain first sub-light and second sub-light; and the first sub-light is directly output from the third end face 2203.

A first light return path (a path shown by arrows in a line shape 2 in FIG. 9) is as follows: The second sub-light obtained by the bidirectional power splitting element 22 through power splitting is emitted to the first total reflector 2311b through the second end face 2202; then, the first total reflector 2311b reflects the second sub-light to the second total reflector 2312b; then, the second total reflector 2312b reflects the second sub-light to the third total reflector 2313b; and the third total reflector 2313b reflects the second sub-light to the second coupling mirror 232b. When the second sub-light is transmitted in the second coupling mirror 232b in a second direction S, a part of the second sub-light is coupled to the micro-ring crystal cavity 25b for resonating; and the resonated light is coupled to the first coupling mirror 212b and transmitted in a third direction Q through the one or more collimation lenses 211b, and then returns to the gain chip 11, to implement self-injection locking.

A second light return path (a path shown by arrows in a line shape 3 in FIG. 9) is as follows: When the second sub-light is transmitted in the second coupling mirror 232b in the second direction S, the other part of the second sub-light is transmitted to the fourth total reflector 24b; the fourth total reflector 24b may reflect the light back to the second coupling mirror 232b, and the light is transmitted in a fourth direction R; and then, a part of the light transmitted in the second coupling mirror 232b in the fourth direction R enters the light splitter 22b through the second end face 2202, then enters the first coupling mirror 212b through the first end face 2201, and returns to the gain chip 11 after being transmitted through the one or more collimation lenses 211b in the third direction Q, to implement self-injection locking again.

A second output path (a path shown by arrows in a line shape 4 in FIG. 9) is as follows: The other part of the light transmitted in the second coupling mirror 232b in the fourth direction R is coupled to the micro-ring crystal cavity 25b for resonating; the resonated light is coupled to the first coupling mirror 212b and transmitted in the first direction P, and enters the light splitter 22b through the first end face 2201; the bidirectional power splitting element 22 performs power splitting to obtain third sub-light and fourth sub-light; and the third sub-light is directly output from the third end face 2203.

According to the foregoing description, similarly, the fourth sub-light may be sequentially emitted to the first total reflector 2311b again, and is similar to the second sub-light, to form a third light return path (the same as a path of the first light return path), a fourth light return path (the same as a path of the second light return path), and a third output path (the second output path). In addition, light that is in the third output path and that enters the light splitter 22b may be further split into fifth sub-light and sixth sub-light, and the fifth sub-light is directly output from the third port 223. The sixth sub-light may continue the foregoing cycle, and the cycle repeats.

Therefore, a plurality of light return paths are formed in the external cavity structure 2 including a plurality of discrete components in this example, to feed more light back to the gain chip 11, so that power $P_r$ fed back to the semiconductor laser chip 1 from the micro-ring external cavity is increased, a linewidth narrowing coefficient $\eta$ is increased, and the linewidth of the external cavity laser 101 is narrowed. In addition, a plurality of output paths are also formed in the external cavity structure 2 including the plurality of discrete components in this example, to increase output optical power. In addition, a structure of the external cavity structure 2 in this example is simple.

It should be noted that the gain chip 11 coupled to the external cavity structure 2 having the plurality of discrete components may alternatively use a solid, a gas, or the like as a gain medium. This is not limited in this application.

In addition, the one or more collimation lenses 211b, the first coupling mirror 212b, the light splitter 22b, the one or more total reflectors 231b, and the second coupling mirror 232b may all transmit light of all spectra. Therefore, an optical power loss in a light transmission process is low, and a frequency deviation caused by a process error is not introduced. In this way, both a linewidth narrowing effect of the external cavity laser 101 and stability of the external cavity laser 101 are good, and a loss of lock does not occur.

In addition, for example, the micro-ring crystal cavity 25b is a 3D structure resonant cavity made of a material like calcium fluoride or magnesium fluoride. Smoothness of manufacturing the micro-ring crystal cavity 25b can be increased, so that a quality factor Q of the micro-ring crystal cavity 25b can be large. For example, the quality factor Q of the micro-ring crystal cavity 25b is greater than $10^8$. This further improves linewidth narrowing performance.

In addition, the one or more collimation lenses 211b, the first coupling mirror 212b, the light splitter 22b, the four or more total reflectors 231b, and the second coupling mirror 232b may all be disposed on a base plate, to facilitate fastening. In addition, the semiconductor laser chip 1 may also be disposed on the base plate, to facilitate optical path coupling between the semiconductor laser chip and the collimation lens 211b.

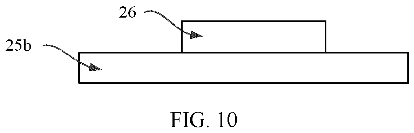

It may be understood that, in some application scenarios, the external cavity laser 101 needs to have a frequency modulation function. Therefore, in some embodiments, the external cavity laser 101 further includes a frequency modulation structure 26 shown in FIG. 10, and the frequency modulation structure 26 is disposed on the micro-ring crystal cavity 25b. The frequency modulation structure 26 may adjust a refractive index of the micro-ring crystal cavity 25b, to adjust a resonance frequency of the micro-ring crystal cavity 25b, so as to change an output frequency of the external cavity laser 101.

For example, the frequency modulation structure 26 may be a frequency modulator made of titanium nitride, and the frequency modulator is disposed on the micro-ring crystal cavity 25b. The frequency modulator performs frequency modulation on the micro-ring crystal cavity 25b in a thermo-optic manner, an electro-optic manner, a photo-elastic manner, or another manner.

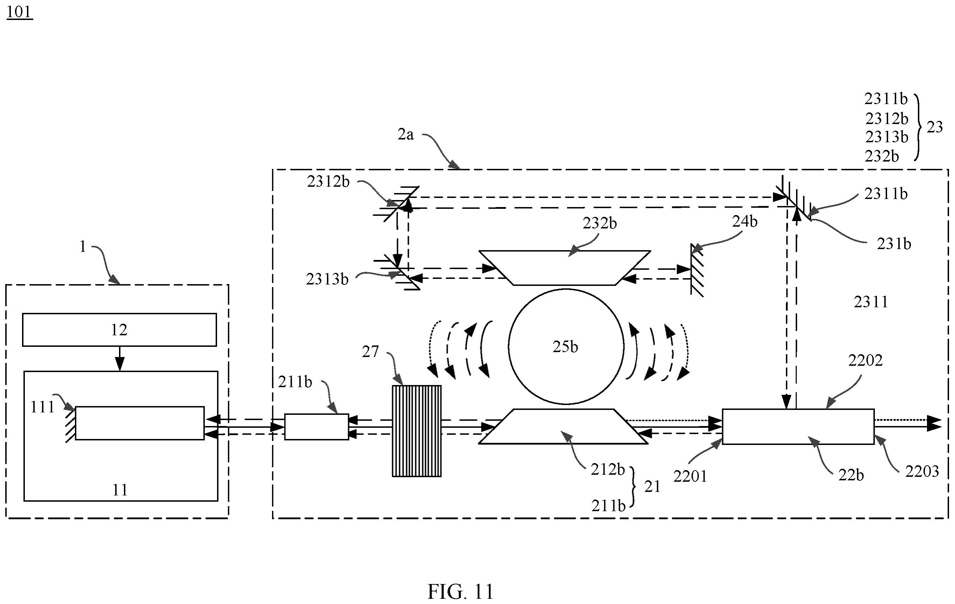

Alternatively, in some embodiments, the external cavity structure 2 further includes a grating 27 shown in FIG. 11. The grating 27 is disposed on a light path between the one or more collimation lenses 211b and the first coupling mirror 212b, or on a light path between the first coupling mirror 212b and the one or more collimation lenses 211b. The grating 27 may select a longitudinal mode of a preset frequency for output. In addition, the grating 27 may be replaced with a Fabry-Perot resonant cavity (Fabry-Pérot cavity, FP), and may also have a frequency selection function.

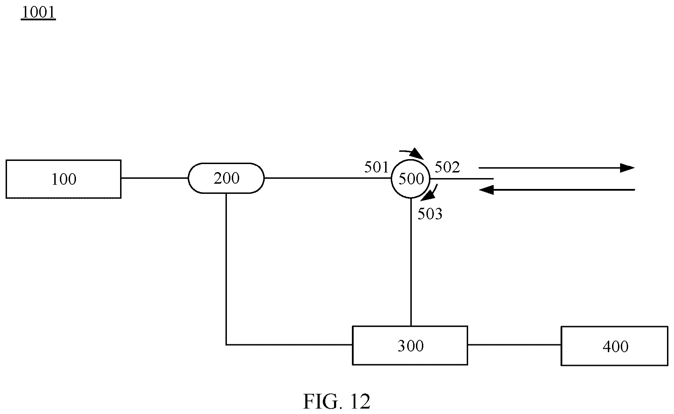

The external cavity laser 101 in this embodiment of this application is described above with reference to two specific examples. When the laser sensing system 1000 in which the two external cavity lasers 101 are used is a frequency modulated continuous wave lidar system, in addition to the laser module 100, the coupler 200, the coherent receiver 300, and the data processor 400, the frequency modulated continuous wave lidar system 1001 may further include a circulator 500 shown in FIG. 12. The circulator 500 has a first interface 501, a second interface 502, and a third interface 503. Light input from the first interface 501 may be output through the second interface 502, and light input from the second interface 502 may be output through the third interface 503. The first interface 501 is connected to the coupler 200, for example, through an optical fiber. The first interface 501 is configured to receive the first sub-light output by the coupler 200, and transmit the first sub-light to the second interface 502 for output. The second interface 502 may receive the first sub-light output from the first interface 501, and output the first sub-light to a to-be-detected target (for example, a person or a vehicle). Reflected light is formed after reflection of the to-be-detected target, and is reflected back to the second interface 502. The third interface 503 receives the reflected light that is from the to-be-detected target and that is input to the second interface 502. The coherent receiver 300 is connected to both the third interface 503 of the circulator 500 and the coupler 200. Therefore, the coherent receiver 300 may specifically receive the reflected light output from the third interface 503 of the circulator 500 and the second sub-light output by the coupler 200, and perform interference and demodulation. The data processor 400 performs data processing on a signal output by the coherent receiver 300, to obtain information such as a location and a speed of the to-be-detected target. Because the external cavity laser 101 in the laser module 100 has an extremely small linewidth, a detectable distance of the frequency modulated continuous wave lidar system 1001 is extremely long.

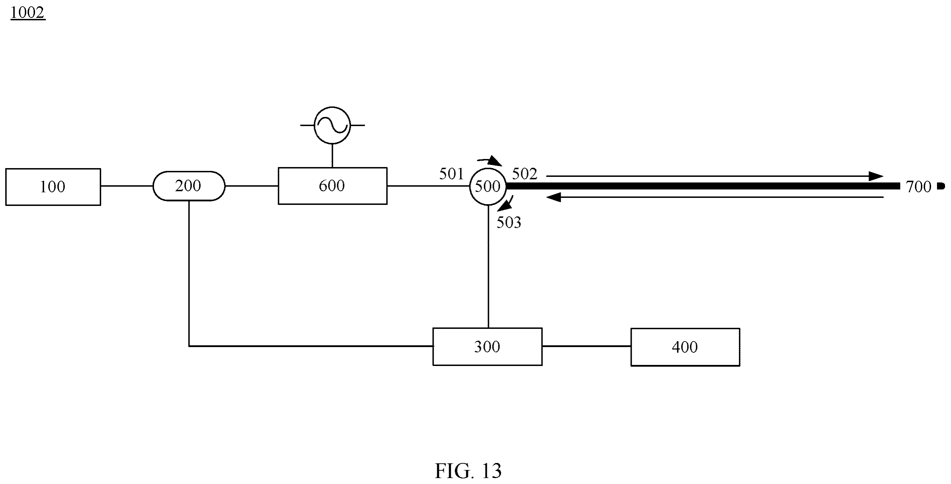

When the laser sensing system 1000 in which the two external cavity lasers 101 are used is a distributed acoustic sensing system, in addition to the foregoing components, the distributed acoustic sensing system 1002 may further include a pulse modulator 600, a circulator 500, an optical fiber 700, and the like that are shown in FIG. 13. The pulse modulator 600 may be connected to the coupler 200, for example, through an optical fiber. The pulse modulator 600 is configured to convert the first sub-light output by the coupler 200 into pulsed light. The circulator 500 has a first interface 501, a second interface 502, and a third interface 503. Light input from the first interface 501 may be output through the second interface 502, and light input from the second interface 502 may be output through the third interface 503. The first interface 501 may be connected to the pulse modulator 600, for example, through an optical fiber. The first interface 501 is configured to receive the pulsed light output by the pulse modulator 600, and transmit the pulsed light to the second interface 502 for output. The optical fiber 700 is disposed on a to-be-detected target. For example, the to-be-detected target is an oil and gas backbone pipeline network. The optical fiber 700 may be disposed on an outer wall of the oil and gas backbone pipeline network, or disposed on a security network. In addition, one end of the optical fiber 700 is connected to the second interface 502 of the circulator 500. Therefore, the optical fiber 700 may receive the pulsed light output from the second interface 502. When the pulsed light is transmitted in the optical fiber 700, reverse scattered light is generated at each location of the optical fiber 700. The scattered light may be Rayleigh scattered light, Raman scattered light, or Brillouin scattered light. Information such as intensity and a phase of the reverse scattered light is related to deformation of the optical fiber at the location. Therefore, whether a third-party intrusion event exists can be reflected. These reversely transmitted scattered light signals may return to the second interface 502 through the optical fiber 700. Therefore, the second interface 502 may further receive the scattered light reflected back by the optical fiber 700 and transmit the scattered light to the third interface 503. The coherent receiver 300 is connected to the third interface 503 of the circulator 500 and the coupler 200. Therefore, the coherent receiver 300 may receive the scattered light output from the third interface 503 of the circulator 500 and the second sub-light output by the coupler 200, perform interference and demodulation on the scattered light and the second sub-light, and finally output a signal. The data processor 400 may perform data processing on the signal output by the coherent receiver 300, to obtain a specific location at which the third-party intrusion event occurs and information such as a location and a speed of the to-be-detected target through analysis. Because the external cavity laser 101 in the laser module 100 has an extremely small linewidth, a pipeline length that can be detected by the distributed acoustic sensing system 1002 is extremely long.

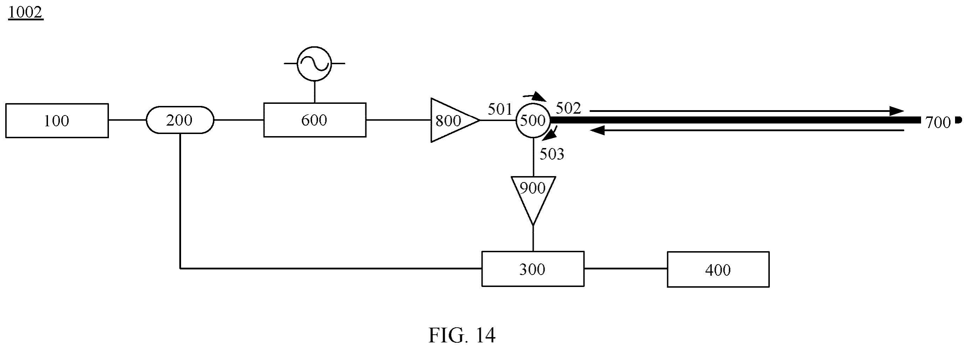

In addition, in some embodiments of this application, as shown in FIG. 14, the distributed acoustic sensing system 1002 further includes a first erbium-doped fiber amplifier 800 (erbium-doped fiber amplifier, EDFA) and a second erbium-doped fiber amplifier 900, and the first erbium-doped fiber amplifier 800 connects the pulse modulator 600 to the first interface 501 of the circulator 500. For example, the first erbium-doped fiber amplifier 800 may be separately connected to the pulse modulator 600 and the first interface 501 of the circulator 500 through optical fibers. The first erbium-doped fiber amplifier 800 may amplify the pulsed light output by the pulse modulator 600. The second erbium-doped fiber amplifier 900 connects the third interface 503 of the circulator 500 to the coherent receiver 300. For example, the second erbium-doped fiber amplifier 900 may be separately connected to the third interface 503 of the circulator 500 and the coherent receiver 300 through optical fibers. The second erbium-doped fiber amplifier 900 may amplify the scattered light output from the third interface 503 of the circulator 500. Therefore, the distributed acoustic sensing system is applicable to an application scenario in which optical power of the pulsed light is low and optical power of the scattered light is low.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

**Claims**

1.  An optical chip, configured to receive light emitted by a gain chip in a laser, and comprising a substrate and a waveguide layer disposed on the substrate, wherein a first optical waveguide, a bidirectional power splitting optical waveguide, a second optical waveguide, a reflective optical waveguide, and a micro-ring optical waveguide are formed on the waveguide layer;

    the bidirectional power splitting optical waveguide has a first port, a second port, and a third port; a first end of the first optical waveguide is configured to be coupled to or connected to an end face of the gain chip in the laser, and a second end of the first optical waveguide is connected to the first port of the bidirectional power splitting optical waveguide; the micro-ring optical waveguide is located on a side of the first optical waveguide; one end of the second optical waveguide is connected to the second port of the bidirectional power splitting optical waveguide, and the other end of the second optical waveguide extends to another side that is of the micro-ring optical waveguide and that is away from the first optical waveguide, and is connected to the reflective optical waveguide; the first optical waveguide and the second optical waveguide are coupled to the micro-ring optical waveguide; and the third port of the bidirectional power splitting optical waveguide is a light output port; and
    the first optical waveguide is configured to: couple, to the micro-ring optical waveguide, the light emitted by the gain chip; receive the light that is coupled after the micro-ring optical waveguide performs resonating, transmit a part of the light to the first port of the bidirectional power splitting optical waveguide, and transmit the other part of the light to the first end of the first optical waveguide; and transmit, to the first end of the first optical waveguide, light output from the first port of the bidirectional power splitting optical waveguide; the bidirectional power splitting optical waveguide is configured to: split the light input from the first port for output through the second port and the third port; and output, to the first port, the light input from the second port; the second optical waveguide is configured to: couple, to the micro-ring optical waveguide, a part of light output from the second port of the bidirectional power splitting optical waveguide, and transmit the other part of the light to the reflective optical waveguide; and transmit, to the second port of the bidirectional power splitting optical waveguide, a part of the light reflected back from the reflective optical waveguide, and couple the other part of the light to the micro-ring optical waveguide; the reflective optical waveguide is configured to reflect, back to the second optical waveguide, the light emitted from the second optical waveguide; and the micro-ring optical waveguide is configured to: resonate the light coupled from the first optical waveguide and the light coupled from the second optical waveguide, and couple light to the first optical waveguide.

2.  The optical chip according to claim 1, wherein the first optical waveguide is a straight waveguide; the second optical waveguide comprises at least two straight waveguides and at least two waveguide corners; the at least two waveguide corners connect the at least two straight waveguides, and connect the straight waveguide in the second optical waveguide to a second port of the micro-ring optical waveguide; and one straight waveguide that is in the second optical waveguide and that is connected to the reflective optical waveguide is parallel to the first optical waveguide.

3.  The optical chip according to claim 1 or 2, wherein the reflective optical waveguide comprises any one of a grating, a Sagnac ring, and a loop mirror loop mirror.

4.  The optical chip according to any one of claims 1 to 3, wherein the bidirectional power splitting optical waveguide comprises any one of a multimode interferometer, a Y-shaped power splitter, and a directional coupler.

5.  The optical chip according to any one of claims 1 to 3, wherein the bidirectional power splitting optical waveguide is any one of a thermo-optic multimode interferometer, an electro-optic multimode interferometer, a photo-elastic multimode interferometer, a thermo-optic Y-shaped power splitter, an electro-optic Y-shaped power splitter, a photo-elastic Y-shaped power splitter, a thermo-optic directional coupler, an electro-optic directional coupler, and a photo-elastic directional coupler.

6.  The optical chip according to any one of claims 1 to 5, wherein the optical chip further comprises:
    a frequency modulation structure, wherein the frequency modulation structure is disposed on the micro-ring optical waveguide, and is configured to adjust a refractive index of the micro-ring optical waveguide.

7.  The optical chip according to any one of claims 1 to 6, wherein the optical chip comprises a plurality of micro-ring optical waveguides coupled to each other, and the plurality of micro-ring optical waveguides are all located between the first optical waveguide and the second optical waveguide, and have different diameters; and
    the plurality of micro-ring optical waveguides comprise a first micro-ring optical waveguide and a second micro-ring optical waveguide, the first micro-ring optical waveguide is coupled to the first optical waveguide, and the second micro-ring optical waveguide is coupled to the second optical waveguide.

8. The optical chip according to claim 7, wherein the plurality of micro-ring optical waveguides further comprise at least one third micro-ring optical waveguide, and the third micro-ring optical waveguide is coupled to the adjacent micro-ring optical waveguide.

9. An external cavity laser, comprising a gain chip configured to emit light, and a first light guide structure, a bidirectional power splitting element, a second light guide structure, a reflection element, and a micro-ring resonator that are disposed on a light outlet side of the gain chip, wherein the first light guide structure, the bidirectional power splitting element, and the second light guide structure are sequentially disposed in a light outlet direction of the gain chip; the bidirectional power splitting element has a first port, a second port, and a third port, the first port faces the first light guide structure, the second port faces the second light guide structure, and the third port is a light outlet; the reflection element is located on a light outlet side of the second light guide structure; and the micro-ring resonator is located between the first light guide structure and the second light guide structure, and is coupled to the first light guide structure and the second light guide structure; and
the first light guide structure is configured to: couple, to the micro-ring resonator, the light emitted by the gain chip; receive the light that is coupled after the micro-ring resonator performs resonating, transmit a part of the light to the first port of the bidirectional power splitting element, and transmit the other part of the light to the gain chip; and transmit, to the gain chip, light output from the first port of the bidirectional power splitting element; the bidirectional power splitting element is configured to: split the light input from the first port for output through the second port and the third port; and output, to the first port, the light input from the second port; the second light guide structure is configured to: couple, to the micro-ring resonator, a part of light output from the second port of the bidirectional power splitting element, and transmit the other part of the light to the reflection element; and transmit, to the second port of the bidirectional power splitting element, a part of the light reflected back from the reflection element, and couple the other part of the light to the micro-ring resonator; the reflection element is configured to reflect, back to the second light guide structure, the light emitted by the second light guide structure; and the micro-ring resonator is configured to: resonate the light coupled from the first light guide structure and the light coupled from the second light guide structure, and couple light to the first light guide structure.

10. The external cavity laser according to claim 9, wherein the external cavity laser further comprises an external cavity chip, the external cavity chip is disposed on the light outlet side of the gain chip, and the external cavity chip comprises a substrate and a waveguide layer disposed on the substrate; the first light guide structure, the bidirectional power splitting element, the second light guide structure, the reflection element, and the micro-ring resonator are all on a same layer and made of a same material, and are all formed on the waveguide layer of the external cavity chip.

11. The external cavity laser according to claim 10, wherein the micro-ring resonator is a micro-ring optical waveguide; the first light guide structure is a straight waveguide; the second light guide structure comprises at least two straight waveguides and at least two waveguide corners; the at least two waveguide corners respectively connect two adjacent straight waveguides in the at least two straight waveguides, and connect the straight waveguide to a second port of the micro-ring resonator; one end of the first light guide structure is coupled to or connected to an end face of the gain chip, and the other end of the first light guide structure is connected to the first port of the bidirectional power splitting element; two ends of the second light guide structure are respectively connected to the second port of the bidirectional power splitting element and the reflection element; and a straight waveguide that is in the second light guide structure and that is connected to the reflection element is parallel to the first light guide structure.

12. The external cavity laser according to claim 10 or 11, wherein the reflection element comprises any one of a grating, a Sagnac Sagnac ring, and a loop mirror loop mirror.

13. The external cavity laser according to any one of claims 10 to 12, wherein the bidirectional power splitting element comprises any one of a multimode interferometer, a Y-shaped power splitter, and a directional coupler.

14. The external cavity laser according to any one of claims 10 to 13, wherein the bidirectional power splitting element comprises any one of a thermo-optic multimode interferometer, an electro-optic multimode interferometer, a photo-elastic multimode interferometer, a thermo-optic Y-shaped power splitter, an electro-optic Y-shaped power splitter, a photo-elastic Y-shaped power splitter, a thermo-optic directional coupler, an electro-optic directional coupler, and a photo-elastic directional coupler.

15. The external cavity laser according to any one of claims 9 to 14, wherein the external cavity laser comprises a plurality of micro-ring resonators coupled to each other, and the plurality of micro-ring resonators are all located between the first light guide structure and the second light guide structure, and have different diameters; and
the plurality of micro-ring resonators comprise a first micro-ring resonator and a second micro-ring resonator that are coupled to each other, the first micro-ring resonator is coupled to the first light guide structure, and the second micro-ring resonator is coupled to the second light guide structure.

16. The external cavity laser according to claim 15, wherein the plurality of micro-ring resonators further comprise at least one third micro-ring resonator, and the third micro-ring resonator is coupled to the adjacent micro-ring resonator.

17. The external cavity laser according to claim 9, wherein the first light guide structure comprises a collimation lens and a first coupling mirror that are sequentially disposed in a light outlet direction of the gain chip; the micro-ring resonator is a micro-ring crystal cavity, and is located on a side of the first coupling mirror; the bidirectional power splitting element is a light splitter, the first port is a surface that is of the light splitter and that is on a light outlet path of the first coupling mirror, and the second port and the third port are respectively other two surfaces of the light splitter; the second light guide structure comprises at least three total reflectors and a second coupling mirror, one of the at least three total reflectors is located on a light outlet path of the second port of the light splitter, and the at least three total reflectors are sequentially disposed in a light path; the second coupling mirror is located on a side that is of the micro-ring resonator and that is away from the first coupling mirror, and is located on an emergent light path of the at least three total reflectors; and the reflection element is a total reflector, and the reflection element is located on a light outlet path of the second coupling mirror.

18. The external cavity laser according to any one of claims 9 to 17, wherein the external cavity laser further comprises: a frequency modulation structure, wherein the frequency modulation structure is disposed on the micro-ring resonator, and is configured to adjust a refractive index of the micro-ring resonator.

19. A laser module, comprising a temperature controller and the external cavity laser according to any one of claims 9 to 18, wherein the temperature controller is in contact with the external cavity laser.

20. A distributed acoustic sensing system, comprising:

the laser module according to claim 19;
a coupler, wherein the coupler is configured to receive light emitted by the external cavity laser and perform power splitting on the light, to output first sub-light and second sub-light;
a pulse modulator, wherein the pulse modulator is connected to the coupler, and is configured to convert the first sub-light output by the coupler into pulsed light;
a circulator, wherein the circulator has a first interface, a second interface, and a third interface; and the first interface is configured to receive the pulsed light output by the pulse modulator and transmit the pulsed light to the second interface;
an optical fiber, wherein the optical fiber is disposed on a to-be-detected target, and is connected to the second interface of the circulator; and the second interface is configured to: receive the pulsed light output from the first interface, and transmit the pulsed light to the optical fiber; and receive scattered light reflected back from the optical fiber, and transmit the scattered light to the third interface;
a coherent receiver, wherein the coherent receiver is connected to the third interface of the circulator and the coupler, and the coherent receiver is configured to receive the scattered light output from the third interface of the circulator and the second sub-light output by the coupler, and perform interference and demodulation; and
a data processor, wherein the data processor is connected to the coherent receiver, and is configured to perform data processing on a signal output by the coherent receiver.

21. The distributed acoustic sensing system according to claim 20, wherein the distributed acoustic sensing system further comprises:

a first erbium-doped fiber amplifier, wherein the first erbium-doped fiber amplifier connects the pulse modulator to the first interface of the circulator, and is configured to amplify the pulsed light output by the pulse modulator; and
a second erbium-doped fiber amplifier, wherein the second erbium-doped fiber amplifier connects the third interface of the circulator to the coherent receiver, and is configured to amplify the scattered light output from the third interface of the circulator.

22. A frequency modulated continuous wave lidar system, comprising:

the laser module according to claim 19;
a coupler, wherein the coupler is configured to receive light emitted by the external cavity laser and perform power splitting on the light, to output first sub-light and second sub-light;
a circulator, wherein the circulator has a first interface, a second interface, and a third interface; the first interface is connected to the coupler, and is configured to receive the first sub-light output by the coupler; the second interface is configured to: receive the first sub-light output from the first interface, transmit the first sub-light to a to-be-detected target, and receive reflected light of the to-be-detected target; and the third interface is configured to receive the reflected light that is of the to-be-detected target and that is output from the second interface;
a coherent receiver, wherein the coherent receiver is connected to the third interface of the circulator and the coupler, and is configured to receive the reflected light output from the third interface of the circulator and the second sub-light output by the coupler, and perform interference and demodulation; and
a data processor, wherein the data processor is connected to the coherent receiver, and is configured to perform data processing on a signal output by the coherent receiver.

23. A laser sensing system, comprising:

the laser module according to claim 19;
a coupler, wherein the coupler is configured to receive light emitted by the external cavity laser and perform power splitting on the light, to output first sub-light and second sub-light;
a coherent receiver, wherein the coherent receiver is configured to: receive the second sub-light output by the coupler and target light that is formed after the first sub-light output by the coupler is transmitted to a to-be-detected target and then returns; and perform interference and demodulation; and
a data processor, wherein the data processor is connected to the coherent receiver, and is configured to perform data processing on a signal output by the coherent receiver.

1000

FIG. 1

Laser module 100

Temperature controller 20

Laser 10

FIG. 2

FIG. 3

101

202

201

FIG. 4

FIG. 5

FIG. 6

FIG. 7

FIG. 8

EP 4 672 519 A1

FIG. 9

EP 4 672 519 A1

26

25b

FIG. 10

FIG. 11

1001

100 — 200 — 501 500 502 →
503
300 — 400

FIG. 12

1002

100

200

600

500

502

503

501

700

300

400

FIG. 13

1002

FIG. 14

## INTERNATIONAL SEARCH REPORT

| International application No. |
|---|
| **PCT/CN2023/142472** |

### A. CLASSIFICATION OF SUBJECT MATTER

H01S5/14(2006.01)i; H01S5/10(2021.01)i

According to International Patent Classification (IPC) or to both national classification and IPC

### B. FIELDS SEARCHED

Minimum documentation searched (classification system followed by classification symbols)

IPC: H01S G02B

Documentation searched other than minimum documentation to the extent that such documents are included in the fields searched

Electronic data base consulted during the international search (name of data base and, where practicable, search terms used)

CNTXT, ENTXTC, DWPI, VEN: 激光, 外腔, 外部腔, 微环, 谐振, 波导, 线宽, 窄, 功率, 循环, 自注入, 锁模, 耦合, 反射, 分束, 分光, laser, external cavity, EC, microring, micro-ring, micro ring, MMR, resonat+, waveguide, wave-guide, wave guide, linewidth, narrow, power, circulat+, self seed+, self inject+, lock+, coupl+, reflect, splitter

### C. DOCUMENTS CONSIDERED TO BE RELEVANT

| Category* | Citation of document, with indication, where appropriate, of the relevant passages | Relevant to claim No. |
|---|---|---|
| A | CN 111613959 A (TSINGHUA UNIVERSITY) 01 September 2020 (2020-09-01) claims 1-15, description, paragraphs 44-70, and figures 1-4 | 1-23 |
| A | CN 112202048 A (UNITED MICROELECTRONICS CENTER CO., LTD.) 08 January 2021 (2021-01-08) entire document | 1-23 |
| A | CN 111434058 A (HUAWEI TECHNOLOGIES CO., LTD.) 17 July 2020 (2020-07-17) entire document | 1-23 |
| A | CN 114899705 A (ANHUI ZHIBO OPTOELECTRONICS TECHNOLOGY CO., LTD.) 12 August 2022 (2022-08-12) entire document | 1-23 |
| A | CN 104067464 A (FUJITSU LTD.) 24 September 2014 (2014-09-24) entire document | 1-23 |
| A | US 9653882 B1 (ORACLE INTERNATIONAL CORP. et al.) 16 May 2017 (2017-05-16) entire document | 1-23 |

☑ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **06 March 2024** | **21 March 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

| International application No. |
| --- |
| **PCT/CN2023/142472** |

### C. DOCUMENTS CONSIDERED TO BE RELEVANT

| Category* | Citation of document, with indication, where appropriate, of the relevant passages | Relevant to claim No. |
| --- | --- | --- |
| A | US 2016049767 A1 (MORTON PAUL A. et al.) 18 February 2016 (2016-02-18)<br>entire document | 1-23 |

Form PCT/ISA/210 (second sheet) (July 2022)

**EP 4 672 519 A1**

| INTERNATIONAL SEARCH REPORT | | | | | | International application No. |
| Information on patent family members | | | | | | **PCT/CN2023/142472** |

| Patent document cited in search report | | | Publication date (day/month/year) | Patent family member(s) | | | Publication date (day/month/year) |
|---|---|---|---|---|---|---|---|
| CN | 111613959 | A | 01 September 2020 | CN | 111613959 | B | 03 December 2021 |
| CN | 112202048 | A | 08 January 2021 | CN | 112202048 | B | 01 February 2022 |
| CN | 111434058 | A | 17 July 2020 | EP | 3714560 | A1 | 30 September 2020 |
| | | | | EP | 3714560 | A4 | 30 December 2020 |
| | | | | WO | 2019120270 | A1 | 27 June 2019 |
| | | | | US | 2019199057 | A1 | 27 June 2019 |
| | | | | US | 10522968 | B2 | 31 December 2019 |
| | | | | CN | 111434058 | B | 04 June 2021 |
| CN | 114899705 | A | 12 August 2022 | | None | | |
| CN | 104067464 | A | 24 September 2014 | US | 2015222089 | A1 | 06 August 2015 |
| | | | | US | 9130350 | B2 | 08 September 2015 |
| | | | | WO | 2013114577 | A1 | 08 August 2013 |
| | | | | JPWO | 2013114577 | A1 | 11 May 2015 |
| | | | | JP | 5772989 | B2 | 02 September 2015 |
| | | | | CN | 104067464 | B | 24 August 2016 |
| US | 9653882 | B1 | 16 May 2017 | | None | | |
| US | 2016049767 | A1 | 18 February 2016 | US | 9559484 | B2 | 31 January 2017 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310311255